# EUROPEAN PATENT APPLICATION

(11) **EP 4 847 664 A1**
(43) Date of publication of application: **02.12.2026**
(21) Application number: 26180985.9
(22) Date of filing: 26.05.2026
(51) Int. Cl.: C23C 28/04, B32B 27/14, C23C 14/34, C23C 14/48, C23C 28/00

(54) **COATED CUTTING TOOL**

(30) Priority: 27.05.2025 JP 2025087768
(71) Applicant: Tungaloy Corporation, Iwaki-shi, Fukushima 970-1144 (JP)
(72) Inventor: KATAGIRI, Takao, Fukushima, 9701144 (JP)
(74) Representative: Vossius & Partner Patentanwälte Rechtsanwälte mbB

(57) **Abstract**

The present invention aims to provide a coated cutting tool that has excellent fracture resistance and wear resistance, a long tool life, and excellent machined surface quality. A coated cutting tool comprising a substrate and a coating layer formed on the substrate, the coating layer having a first layer containing a compound having a specific composition, and a second layer being in contact with the first layer and containing a compound having a specific composition, the first and second layers having an area proportion of crystal grains showing a GOS value of 2 degrees or more of 10 area% or more and less than 40 area%, and the first and second layers having a total average thickness of 0.1 µm or more and 3.0 µm or less.

## Description

### BACKGROUND OF THE INVENTION

### Field of the Invention

The present invention relates to a coated cutting tool.

### Description of the Related Art

Conventionally widely used coated cutting tools include a substrate made of cemented carbide, cermet, cubic boron nitride (cBN) sintered body, or the like, and a coating layer in which one or more metal nitride layers, such as TiN or TiAlN layers, are formed by vapor deposition on the surface of the substrate. For the purpose of enhancing the performance of coated cutting tools, various proposals have been made to improve their coating layers.

For example, Japanese Patent Laid-Open No. 2017-077599 describes a surface-coated cutting tool in which a hard coating layer is formed on the surface of a tool base made of tungsten carbide-based cemented carbide, titanium carbonitride-based cermet, or a cubic crystal boron nitride-based ultra-high pressure sintered body, wherein
(a) the hard coating layer is composite nitride of Cr and Al having an average layer thickness of 1 to 15 µm, and when its composition is represented by the composition formula: (Cr₁₋ₓAlₓ)N, the average content ratio x_{avg} (wherein x_{avg} is the atomic ratio) of Al in the total amount of Cr and Al in the composite nitride layer satisfies 0.40≤x_{avg}≤0.95,
(b) the composite nitride layer contains a phase of composite nitride of Cr and Al having a NaCl-type face-centered cubic structure,
(c) the compressive residual stress of the composite nitride layer satisfies 1.0 GPa to 8.0 GPa, and
(d) when a crystal orientation of crystal grains in the composite nitride of Cr and Al having a NaCl-type face-centered cubic structure is analyzed from a longitudinal section direction using an electron backscatter diffraction device to determine the intragranular average misorientation of the individual crystal grains, the area of crystal grains whose intragranular average misorientation is 2 degrees or more occupies 10% or more of the area of the composite nitride layer.

The automation of cutting equipment has been remarkable in recent years, and this has led to a demand for coated cutting tools that show excellent chipping resistance, peeling resistance, and wear resistance over a long period of time. It is also difficult to increase the cutting speed in bar machining with an NC automatic lathe or the like. Therefore, the formation of built-up edge, and chipping and peeling due to the falling off of the built-up edge are likely to occur, causing a problem that the cutting edge portion is chipped from the chipped or peeled areas. In order to solve this problem, there has been a proposal for a coated cutting tool with a sharp cutting edge portion that is not honed or has a small honing size. However, such a coated cutting tool with a cutting edge portion is easily chipped due to the reduced strength of the cutting edge portion, and welding of pieces of the workpiece material at the chipped area causes machined surface quality issues, such as damage to the machined surface of the workpiece material and white turbidity.

The present invention has been made in light of the above circumstances, and an object thereof is to provide a coated cutting tool that has excellent fracture resistance and wear resistance, a long tool life, and excellent machined surface quality.

### SUMMARY OF THE INVENTION

From the above point of view, the present inventor has conducted extensive research on how to achieve both the extended tool life and machined surface quality of coated cutting tools, and has found that a coated cutting tool with a specific configuration has excellent fracture resistance and wear resistance, consequently extending the tool life of the coated cutting tool and ensuring excellent machined surface quality. Thus, the present invention has been completed.

Specifically, the present invention is as described below.
<1> A coated cutting tool comprising a substrate and a coating layer formed on the substrate,
   the coating layer having a first layer containing a compound having a composition represented by the following formula (1), and
   a second layer being in contact with the first layer and containing a compound having a composition represented by the following formula (2):

      (Crₓ₁Al_{y1}M_{1-x1-y1})N (1)

      (Crₓ₂Al_{y2}M_{1-x2-y2})N (2)

      (in the formula (1), M represents at least one element selected from the group consisting of Mo, W, V, Nb, Ta, Ti, Zr, Hf, Si, and B,
   x1 is the atomic ratio of Cr to the sum of elements represented by Cr, Al, and M, and satisfies 0.05≤x1≤0.40, and
   y1 is the atomic ratio of Al to the sum of elements represented by Cr, Al, and M, and satisfies 0.60≤y1≤0.95, and
      in the formula (2), M represents at least one element selected from the group consisting of Mo, W, V, Nb, Ta, Ti, Zr, Hf, Si, and B,
   x2 is the atomic ratio of Cr to the sum of elements represented by Cr, Al, and M, and satisfies 0.40≤x2≤0.80, and
   y2 is the atomic ratio of Al to the sum of elements represented by Cr, Al, and M, and satisfies 0.20≤y2<0.60),
   the first and second layers having an area proportion of crystal grains showing a GOS value of 2 degrees or more of 10 area% or more and less than 40 area%, and
   the first and second layers having a total average thickness of 0.1 µm or more and 3.0 µm or less.
<2> The coated cutting tool according to <1>, wherein the first layer has an average thickness of 2 nm or more and 1500 nm or less, and
   the second layer has an average thickness of 2 nm or more and 1500 nm or less.
<3> The coated cutting tool according to <1> or <2>, wherein crystal grains that constitute the first and second layers have an average aspect ratio of 1.5 or more and 10.0 or less.
<4> The coated cutting tool according to any one of <1> to <3>, wherein crystal grains that constitute the first and second layers have an average grain size of 100 nm or more and 1000 nm or less.
<5> The coated cutting tool according to any one of <1> to <4>, wherein all compounds in the first and second layers have an average composition represented by the following formula (3):

   (CrₓAl_{y}M_{1-x-y})N (3)

   (in the formula (3), M represents at least one element selected from the group consisting of Mo, W, V, Nb, Ta, Ti, Zr, Hf, Si, and B,
   x is the atomic ratio of Cr to the sum of elements represented by Cr, Al, and M, and satisfies 0.30≤x≤0.60, and
   y is the atomic ratio of Al to the sum of elements represented by Cr, Al, and M, and satisfies 0.40≤y≤0.70.).
<6> The coated cutting tool according to any one of <1> to <5>, wherein the coating layer has an alternately layered structure in which the first layer and the second layer are alternately formed two or more times.
<7> The coated cutting tool according to any one of <1> to <6>, wherein the entire coating layer has an average thickness of 0.1 µm or more and 3.0 µm or less.
<8> The coated cutting tool according to any one of <1> to <7>, wherein the substrate is cemented carbide, cermet, ceramics, or a cubic boron nitride sintered body.

### [Advantageous Effects of Invention]

According to the present invention, it is possible to provide a coated cutting tool that has excellent fracture resistance and wear resistance, a long tool life, and excellent machined surface quality.

### BRIEF DESCRIPTION OF THE DRAWINGS

FIG. 1 is a schematic cross-sectional view showing an example of the coated cutting tool of the present invention; and
FIG. 2 is a schematic cross-sectional view showing another example of the coated cutting tool of the present invention.

### DETAILED DESCRIPTION OF THE INVENTION

Referring to the drawings as necessary, an embodiment for carrying out the present invention (hereinafter simply referred to as "the present embodiment") will be described in detail below; however, the present invention is not limited to the present embodiment described below. The present invention can be modified in various ways without departing from the gist thereof. In the drawings, the positional relationships, such as up, down, left, and right, are based on the positional relationships shown in the drawings, unless otherwise specified. Furthermore, the dimensional ratios in the drawings are not limited to the ratios shown in the drawings.

### <Coated Cutting Tool>

The coated cutting tool of the present embodiment is a coated cutting tool comprising a substrate and a coating layer formed on the substrate,
the coating layer having a first layer containing a compound having a composition represented by the following formula (1), and
a second layer being in contact with the first layer and containing a compound having a composition represented by the following formula (2):

   (Crₓ₁Al_{y1}M_{1-x1-y1})N (1)

   (Crₓ₂Al_{y2}M_{1-x2-y2})N (2)

   (in the formula (1), M represents at least one element selected from the group consisting of Mo, W, V, Nb, Ta, Ti, Zr, Hf, Si, and B,
x1 is the atomic ratio of Cr to the sum of elements represented by Cr, Al, and M, and satisfies 0.05≤x1≤0.40, and
y1 is the atomic ratio of Al to the sum of elements represented by Cr, Al, and M, and satisfies 0.60≤y1≤0.95, and
   in the formula (2), M represents at least one element selected from the group consisting of Mo, W, V, Nb, Ta, Ti, Zr, Hf, Si, and B,
x2 is the atomic ratio of Cr to the sum of elements represented by Cr, Al, and M, and satisfies 0.40≤x2≤0.80, and
y2 is the atomic ratio of Al to the sum of elements represented by Cr, Al, and M, and satisfies 0.20≤y2<0.60),
the first and second layers having an area proportion of crystal grains showing a GOS value of 2 degrees or more of 10 area% or more and less than 40 area%, and
the first and second layers having a total average thickness of 0.1 µm or more and 3.0 µm or less.

The details of the factor that this coated cutting tool has excellent fracture resistance and wear resistance, a long tool life, and excellent machined surface quality are unclear, but are estimated as follows. However, the factor is not limited to the following.

Since the coating layer has a first layer containing a compound having a composition represented by the above formula (1), and a second layer being in contact with the first layer and containing a compound having a composition represented by the above formula (2), the development of cracks formed during cutting towards the substrate can be suppressed, resulting in excellent fracture resistance. If x1 is 0.40 or less, the hardness is improved, resulting in excellent wear resistance. On the other hand, if x1 is 0.05 or more, the adhesion to the second layer is improved, and peeling is less likely to occur; thus, the fracture resistance is excellent, and the excellent machined surface quality can be maintained for a long period of time. If y1 is 0.95 or less, the formation of hexagonal crystals is suppressed, and the hardness is improved, resulting in excellent wear resistance. On the other hand, if y1 is 0.60 or more, the hardness and oxidation resistance are improved, resulting in excellent wear resistance. If x2 is 0.80 or less, the adhesion to the first layer is improved, and peeling is less likely to occur; thus, the fracture resistance is excellent, and the excellent machined surface quality can be maintained for a long period of time. On the other hand, if x2 is 0.40 or more, welding of the workpiece material to the cutting edge portion is suppressed during cutting, and chipping and peeling are less likely to occur; thus, the fracture resistance is excellent, and the excellent machined surface quality can be maintained for a long period of time. If y2 is less than 0.60, the coating layer having first and second layers can effectively and reliably exhibit the effect of suppressing the development of cracks formed during cutting towards the substrate, resulting in excellent fracture resistance. On the other hand, if y2 is 0.20 or more, the hardness and oxidation resistance are improved, resulting in excellent wear resistance. If the area proportion of crystal grains showing a GOS value of 2 degrees or more is less than 40 area% in the first and second layers, the concentration of residual stress on the cutting edge line is reduced, and chipping and peeling are less likely to occur in the coating layer after vapor deposition; thus, the excellent machined surface quality can be maintained for a long period of time. On the other hand, if the area proportion of crystal grains showing a GOS value of 2 degrees or more is 10 area% or more, the hardness and toughness are improved, resulting in excellent wear resistance and fracture resistance. If the total average thickness of the first and second layers is 3.0 µm or less, the concentration of residual stress on the cutting edge line is reduced, and chipping and peeling are less likely to occur in the coating layer after vapor deposition; thus, the excellent machined surface quality can be maintained for a long period of time. In addition, since chipping and peeling are less likely to occur during cutting, the fracture resistance is excellent. On the other hand, if the total average thickness of the first and second layers is 0.1 µm or more, the wear resistance is excellent. Due to the combination of these configurations, the coated cutting tool of the present embodiment is considered to have excellent fracture resistance and wear resistance, a long tool life, and excellent machined surface quality.

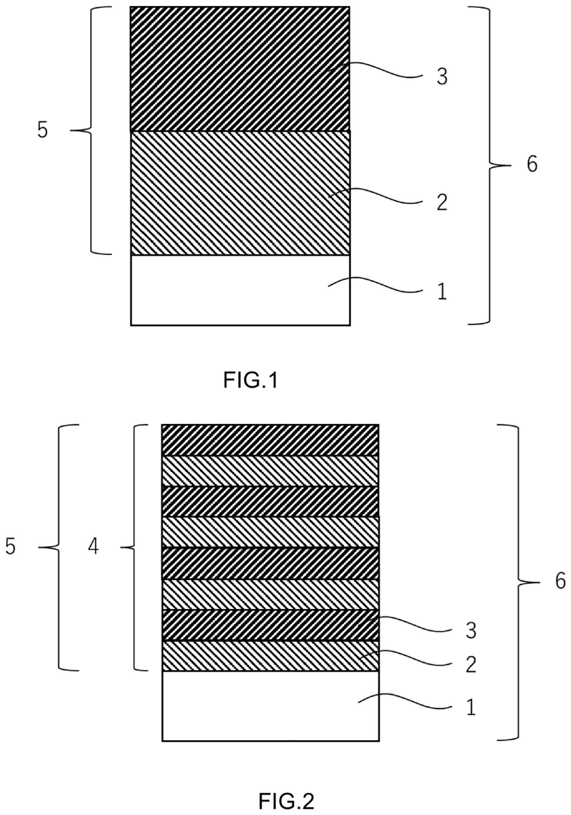

FIG. 1 is a cross-sectional schematic diagram showing an example of the coated cutting tool of the present embodiment. The coated cutting tool 6 comprises a substrate 1 and a coating layer 5 formed on a surface of the substrate 1, and on the coating layer 5, a first layer 2 and a second layer 3 are layered upwards in this order from the side of the substrate 1.

### <Substrate>

The coated cutting tool of the present embodiment includes a substrate and a coating layer formed on the substrate. The substrate used in the present embodiment is not particularly limited as long as it can be used as a substrate for a coated cutting tool. Examples of the substrate include cemented carbide, cermet, ceramics, a cubic boron nitride sintered body, a diamond sintered body, high-speed steel, and the like. Among these, the substrate is preferably cemented carbide, cermet, ceramics, or a cubic boron nitride sintered body, from the viewpoint that the coated cutting tool tends to have more excellent wear resistance and fracture resistance.

### <Coating Layer>

In the coated cutting tool of the present embodiment, the average thickness of the entire coating layer is preferably 0.1 µm or more and 3.0 µm or less. In the coated cutting tool of the present embodiment, if the average thickness of the entire coating layer is 0.1 µm or more, the wear resistance tends to be excellent. On the other hand, if the average thickness of the entire coating layer is 3.0 µm or less, the concentration of residual stress on the cutting edge line is reduced, and chipping and peeling are less likely to occur in the coating layer after vapor deposition; thus, there is a tendency that the excellent machined surface quality can be maintained for a long period of time. In addition, since chipping and peeling are less likely to occur during cutting, the fracture resistance tends to be excellent. From a similar point of view, the average thickness of the entire coating layer is more preferably 0.2 µm or more and 2.8 µm or less, and even more preferably 0.5 µm or more and 1.8 µm or less.

### <First Layer>

In the coated cutting tool of the present embodiment, the first layer is a layer containing a compound having a composition represented by the following formula (1):

(Crₓ₁Al_{y1}M_{1-x1-y1}) N (1)

In the formula (1), M represents at least one element selected from the group consisting of Mo, W, V, Nb, Ta, Ti, Zr, Hf, Si, and B; x1 is the atomic ratio of Cr to the sum of elements represented by Cr, Al, and M, and satisfies 0.05≤x1≤0.40; and y1 is the atomic ratio of Al to the sum of elements represented by Cr, Al, and M, and satisfies 0.60≤y1≤0.95.

In the first layer, if x1 in (Crₓ₁Al_{y1}M_{1-x1-y1})N, which is the composition represented by the formula (1), is 0.40 or less, the hardness is improved, resulting in excellent wear resistance. On the other hand, if x1 is 0.05 or more, the adhesion to the second layer is improved, and peeling is less likely to occur; thus, the fracture resistance is excellent, and the excellent machined surface quality can be maintained for a long period of time. From a similar point of view, x1 is preferably 0.06 or more and 0.38 or less, and more preferably 0.08 or more and 0.36 or less. If y1 is 0.95 or less, the formation of hexagonal crystals is suppressed, and the hardness is improved, resulting in excellent wear resistance. On the other hand, if y1 is 0.60 or more, the hardness and oxidation resistance are improved, resulting in excellent wear resistance. From a similar point of view, y1 is preferably 0.64 or more and 0.92 or less, and more preferably 0.68 or more and 0.90 or less.

In the first layer, x1+y1 in (Crₓ₁Al_{y1}M_{1-x1-y1})N, which is the composition represented by the formula (1), is preferably 0.80 or more and 1.00 or less. If x1+y1 is 0.80 or more and 1.00 or less, the balance between wear resistance and fracture resistance tends to be excellent. From a similar point of view, x1+y1 is more preferably 0.90 or more, and even more preferably 1.00.

When the first layer contains an element represented by M, the element represented by M in the formula (1) is at least one selected from the group consisting of Mo, W, V, Nb, Ta, Ti, Zr, Hf, Si, and B. Among these, from the viewpoint of excellent fracture resistance, the element represented by M is preferably at least one selected from the group consisting of Mo, W, V, Nb, Ta, Ti, Si, and B; and more preferably at least one selected from the group consisting of W, Nb, Ta, Ti, and B.

In the present embodiment, the composition of the compound represented by the formula (1) in the first layer, the composition of the compound represented by the formula (2) in the second layer described later, and the average composition of all compounds in the first and second layers can be measured by the methods described in the Examples provided later.

In the present embodiment, when the composition of each compound is expressed as (Cr_{0.06}Al_{0.90}M_{0.04})N, for example, this means that the atomic ratio of Cr to the sum of elements represented by Cr, Al, and M is 0.06, that the atomic ratio of Al to the sum of elements represented by Cr, Al, and M is 0.90, and that the atomic ratio of M to the sum of elements represented by Cr, Al, and M is 0.04. That is, this means that the amounts of elements represented by Cr, Al, and M to the sum of elements represented by Cr, Al, and M are 6%, 90%, and 4%, respectively.

In the present embodiment, the average thickness of the first layer is preferably 2 nm or more and 1500 nm or less. If the average thickness of the first layer is 2 nm or more, the development of cracks formed during cutting towards the substrate can be suppressed, and the hardness is also improved; thus, the fracture resistance and wear resistance tend to be excellent. In addition, it tends to be easy to form a uniform compound layer. On the other hand, if the average thickness of the first layer is 1500 nm or less, the compressive residual stress is prevented from becoming too high, thereby chipping and peeling are less likely to occur in the coating layer after vapor deposition; thus, there is a tendency that the excellent machined surface quality can be maintained for a long period of time. From a similar point of view, the average thickness of the first layer is more preferably 50 nm or more and 900 nm or less, and even more preferably 90 nm or more and 450 nm or less.

### <Second Layer>

In the coated cutting tool of the present embodiment, the second layer is a layer containing a compound having a composition represented by the following formula (2):

(Crₓ₂Al_{y2}M_{1-x2-y2})N (2)

In the formula (2), M represents at least one element selected from the group consisting of Mo, W, V, Nb, Ta, Ti, Zr, Hf, Si, and B; x2 is the atomic ratio of Cr to the sum of elements represented by Cr, Al, and M, and satisfies 0.40≤x2≤0.80; and y2 is the atomic ratio of Al to the sum of elements represented by Cr, Al, and M, and satisfies 0.20≤y2<0.60.

In the second layer, if x2 in (Crₓ₂Al_{y2}M_{1-x2-y2})N, which is the composition represented by the formula (2), is 0.80 or less, the adhesion to the first layer is improved, and peeling is less likely to occur; thus, the fracture resistance is excellent, and the excellent machined surface quality can be maintained for a long period of time. On the other hand, if x2 is 0.40 or more, welding of the workpiece material to the cutting edge portion is suppressed during cutting, and chipping and peeling are less likely to occur; thus, the fracture resistance is excellent, and the excellent machined surface quality can be maintained for a long period of time. From a similar point of view, x2 is preferably 0.44 or more and 0.70 or less, and more preferably 0.50 or more and 0.70 or less. If y2 is less than 0.60, the coating layer having first and second layers can effectively and reliably exhibit the effect of suppressing the development of cracks formed during cutting towards the substrate, resulting in excellent fracture resistance. On the other hand, if y2 is 0.20 or more, the hardness and oxidation resistance are improved, resulting in excellent wear resistance. From a similar point of view, y2 is preferably 0.24 or more and 0.56 or less, and more preferably 0.30 or more and 0.50 or less.

In the second layer, x2+y2 in (Crₓ₂Al_{y2}M_{1-x2-y2})N, which is the composition represented by the formula (2), is preferably 0.80 or more and 1.00 or less. If x2+y2 is 0.80 or more and 1.00 or less, the balance between wear resistance and fracture resistance tends to be excellent. From a similar point of view, x2+y2 is more preferably 0.90 or more, and even more preferably 1.00.

When the second layer contains an element represented by M, the element represented by M in the formula (2) is at least one selected from the group consisting of Mo, W, V, Nb, Ta, Ti, Zr, Hf, Si, and B. Among these, from the viewpoint of excellent fracture resistance, the element represented by M is preferably at least one selected from the group consisting of Mo, W, V, Nb, Ta, Ti, Si, and B; and more preferably at least one selected from the group consisting of Mo, W, V, Ti, and Si.

In the present embodiment, the average thickness of the second layer is preferably 2 nm or more and 1500 nm or less. If the average thickness of the second layer is 2 nm or more, the development of cracks formed during cutting towards the substrate can be suppressed, and the hardness is also improved; thus, the fracture resistance and wear resistance tend to be excellent. In addition, it tends to be easy to form a uniform compound layer. On the other hand, if the average thickness of the second layer is 1500 nm or less, grain coarsening is suppressed, and chipping is less likely to occur; thus, the fracture resistance tends to be excellent. From a similar point of view, the average thickness of the second layer is more preferably 50 nm or more and 900 nm or less, and even more preferably 90 nm or more and 450 nm or less.

In the present embodiment, the total average thickness of the first and second layers is 0.1 µm or more and 3.0 µm or less. If the total average thickness of the first and second layers is 3.0 µm or less, the concentration of residual stress on the cutting edge line is reduced, and chipping and peeling are less likely to occur in the coating layer after vapor deposition; thus, the excellent machined surface quality can be maintained for a long period of time. In addition, chipping and peeling are less likely to occur during cutting, resulting in excellent fracture resistance. On the other hand, if the total average thickness of the first and second layers is 0.1 µm or more, the wear resistance is excellent. From a similar point of view, the total average thickness of the first and second layers is more preferably 0.2 µm or more and 2.8 µm or less, even more preferably 0.5 µm or more and 1.8 µm or less, and still more preferably 0.5 µm or more and less than 1.0 µm.

In the present embodiment, the average aspect ratio of the crystal grains that constitute the first and second layers is preferably 1.5 or more and 10.0 or less. If the average aspect ratio of the crystal grains that constitute the first and second layers is 1.5 or more, the hardness is improved, and the wear resistance thus tends to be excellent. On the other hand, if the average aspect ratio of the crystal grains that constitute the first and second layers is 10.0 or less, the toughness is improved, and the fracture fracture resistance thus tends to be excellent. From a similar point of view, the average aspect ratio of the crystal grains that constitute the first and second layers is more preferably 2.2 or more and 9.5 or less, and even more preferably 2.4 or more and 8.2 or less.

An average aspect ratio of 1.5 or more indicates that the first and second layers have a columnar crystal structure.

In the present embodiment, the average aspect ratio of the crystal grains that constitute the first and second layers can be measured by the method described in the Examples provided later.

In the present embodiment, the average grain size of the crystal grains that constitute the first and second layers is preferably 100 nm or more and 1000 nm or less. If the average grain size of the crystal grains that constitute the first and second layers is 100 nm or more, the compressive residual stress is prevented from becoming too high, thereby chipping and peeling are less likely to occur in the coating layer after vapor deposition; thus, there is a tendency that the excellent machined surface quality can be maintained for a long period of time. In addition, since chipping and peeling are also less likely to occur during cutting, the fracture resistance tends to be excellent. On the other hand, if the average grain size of the crystal grains that constitute the first and second layers is 1000 nm or less, the hardness is improved, and the wear resistance thus tends to be excellent. From a similar point of view, the average grain size of the crystal grains that constitute the first and second layers is more preferably 150 nm or more and 900 nm or less, and even more preferably 200 nm or more and 800 nm or less.

In the present embodiment, the average grain size of the crystal grains that constitute the first and second layers can be measured by the method described in the Examples provided later.

In the present embodiment, the average composition of all compounds in the first and second layers is preferably represented by the following formula (3):

(CrₓAl_{y}M_{1-x-y})N (3)

It is preferable that in the formula (3), M represents at least one element selected from the group consisting of Mo, W, V, Nb, Ta, Ti, Zr, Hf, Si, and B; x is the atomic ratio of Cr to the sum of elements represented by Cr, Al, and M, and satisfies 0.30≤x≤0.60; and y is the atomic ratio of Al to the sum of elements represented by Cr, Al, and M, and satisfies 0.40≤y≤0.70.

If x in (CrₓAl_{y}M_{1-x-y})N, which is the average composition of all compounds in the first and second layers, is 0.30 or more, welding of the workpiece material to the cutting edge portion is suppressed during cutting, and chipping and peeling are less likely to occur; thus, the fracture resistance tends to be excellent. On the other hand, if x is 0.60 or less, the hardness is improved, and the wear resistance thus tends to be excellent. From a similar point of view, x is more preferably 0.32 or more and 0.55 or less, and even more preferably 0.34 or more and 0.50 or less. If y is 0.40 or more, the hardness and oxidation resistance are improved, and the wear resistance thus tends to be excellent. On the other hand, if y is 0.70 or less, the formation of hexagonal crystals is suppressed, the hardness is improved, and the wear resistance thus tends to be excellent. From a similar point of view, y is more preferably 0.45 or more and 0.68 or less, and even more preferably 0.50 or more and 0.66 or less. x+y is preferably 0.90 or more and 1.00 or less. If x+y is 0.90 or more and 1.00 or less, the balance between wear resistance and fracture resistance tends to be excellent. From a similar point of view, x+y is more preferably 0.95 or more, and even more preferably 1.00.

When the first layer and/or the second layer contains an element represented by M, the element represented by M in the formula (3) is more preferably at least one selected from the group consisting of Mo, W, V, Nb, Ta, Ti, Si, and B, from the viewpoint of excellent fracture resistance.

### <GOS Value>

The computational method for quantifying intragranular strain by electron backscatter diffraction (hereinafter referred to as "EBSD") pattern analysis using a scanning electron microscope (hereinafter referred to as "SEM") is, for example, grain orientation spread (hereinafter referred to as "GOS") that quantifies the intragranular average misorientation. The GOS value will be described below.

A small GOS value indicates that intragranular strain distribution approaches uniformity. If the area proportion of crystal grains with a small GOS value increases, the concentration of residual stress on the cutting edge line is reduced, and chipping and peeling are less likely to occur in the coating layer after vapor deposition; thus, the excellent machined surface quality can be maintained for a long period of time. On the other hand, a large GOS value indicates that crystal grains have a large strain. If the area proportion of crystal grains with a large GOS value increases, the hardness and toughness are improved, resulting in excellent wear resistance and fracture resistance.

In the coated cutting tool of the present embodiment, the area proportion of crystal grains showing a GOS value of 2 degrees or more is 10 area% or more and less than 40 area% in the first and second layers. If the area proportion of crystal grains showing a GOS value of 2 degrees or more is less than 40 area% in the first and second layers, the concentration of residual stress on the cutting edge line is reduced, and chipping and peeling are less likely to occur in the coating layer after vapor deposition; thus, the excellent machined surface quality can be maintained for a long period of time. On the other hand, if the area proportion of crystal grains showing a GOS value of 2 degrees or more is 10 area% or more, the hardness and toughness are improved, resulting in excellent wear resistance and fracture resistance. From a similar point of view, the area proportion of crystal grains showing a GOS value of 2 degrees or more is preferably 11 area% or more and 38 area% or less, and more preferably 12 area% or more and 34 area% or less, in the first and second layers.

In the present embodiment, the GOS value can be measured in the following manner. A sample of the coated cutting tool is polished in a direction substantially perpendicular to the surface of the substrate to expose cross-sections of the first and second layers. Using EBSD (manufactured by TSL Solutions K.K.), each measurement area in the cross-sections of the first and second layers is divided into regular hexagonal measurement points (hereinafter also referred to as "pixels"). For each of the divided pixels, a Kikuchi pattern is obtained from the backscattered electrons from an electron beam incident on the cross-section (polished surface) of the sample, and the pixel orientation is measured. The obtained orientation data are analyzed by using the analysis software of the EBSD, and various parameters are calculated. The measurement conditions are an acceleration voltage of 15 kV and an irradiation current of 1.0 nA, the measurement area is 20 µm in a direction substantially parallel to the substrate surface, and spans a range including all first and second layers in a direction substantially perpendicular to the substrate surface, and the distance between adjacent pixels (step size) is 0.02 µm. If there is a misorientation of 5 degrees or more between adjacent pixels, this is defined as a grain boundary. A region surrounded by grain boundaries is defined as a single crystal grain. However, a single pixel with a misorientation of 5 degrees or more from all adjacent pixels is not considered as a crystal grain, and two or more connected pixels are treated crystal grains.

Then, the intragranular misorientation between two different pixels in the same crystal grain is calculated, and the average intragranular misorientation is defined as the GOS value. That is, the GOS value can be represented by the following formula (4).$GOS = \frac{{\sum }_{i , j = 1}^{n} {α}_{ij \left(i\neq j\right)}}{n \left(n-1\right)}$ (4)

In the formula (4), n represents the number of pixels in the same crystal grain, i and j represent numbers assigned to different pixels in the crystal grain (wherein 1≤i and j≤n) , and αᵢⱼ (i#j) represents the misorientation resulting from the crystal orientation at pixel i and the crystal orientation at pixel j.

Measurements are carried out in five fields of view under the above measurement conditions and within the above measurement range. Next, the total number of pixels belonging to the crystal grains (e.g., cubic crystals) that constitute the first and second layers is determined, the GOS value is divided into one-degree intervals, and the number of pixels in crystal grains whose GOS values are within the range of the value is summed up, followed by dividing by the total number of pixels, thereby creating a histogram that shows the area proportion of GOS values in the first and second layers. Based on the created histogram, the area proportion of crystal grains showing a GOS value of 2 degrees or more in the first and second layers can be determined.

### <Layered Structure>

In the present embodiment, the coating layer preferably has an alternately layered structure in which first and second layers are alternately formed two or more times. The lamination unit in the alternately layered structure with repeatedly formed layers is not particularly limited as long as first and second layers are included. For example, the lamination unit may be such that first and second layers are formed in this order from the substrate side towards the surface of the coating layer, or may be such that second and first layers are formed in this order from the substrate side towards the surface of the coating layer.

FIG. 2 is a cross-sectional schematic diagram showing another example of the coated cutting tool of the present embodiment. The coated cutting tool 6 comprises a substrate 1 and a coating layer 5 formed on a surface of the substrate 1, and the coating layer 5 includes an alternately layered structure 4 in which a lamination unit of a first layer 2 and a second layer 3 formed in order from the side of the substrate 1 is repeatedly formed. In the alternately layered structure 4 shown in FIG. 2, a lamination unit composed of a first layer 2 and a second layer 3 is formed four times.

In the coated cutting tool of the present embodiment, the number of repetitions of the lamination unit including first and second layers in the alternately layered structure is more preferably 3 or more and 200 or less, and even more preferably 5 or more and 100 or less. Since the number of repetitions of the lamination unit including first and second layers is within the above range, the fracture resistance tends to be further improved.

In the present embodiment, for example, when a single first layer and a single second layer are formed, "the number of repetitions" of the lamination unit including first and second layers is 1.

### <Method for Producing Coating Layer>

The method for producing the coating layer in the coated cutting tool of the present embodiment is not particularly limited, and examples thereof include physical vapor deposition methods, such as an ion plating method, an arc ion plating method, a sputtering method, and an ion mixing method. Use of a physical vapor deposition method to form a coating layer is preferred because a sharp edge can be formed. Among these, an arc ion plating method is more preferred because the adhesion between the coating layer and the substrate is more excellent.

### <Method for Producing Coated Cutting Tool>

The method for producing a coated cutting tool of the present embodiment will be described below using specific examples. The method for producing a coated cutting tool of the present embodiment is not particularly limited as long as the configuration of the coated cutting tool can be achieved.

First, a substrate processed into a tool shape is placed in the reaction vessel of a physical vapor deposition device, and a metal evaporation source is placed in the reaction vessel. Then, the reaction vessel is evacuated to a pressure of 1.0×10⁻² Pa or less, and the substrate is heated to a temperature of 200 to 700°C using a heater inside the reaction vessel. After heating, Ar gas is introduced into the reaction vessel, and the pressure in the reaction vessel is set to 0.5 Pa to 5.0 Pa. In an Ar gas atmosphere at a pressure of 0.5 Pa to 5.0 Pa, a bias voltage of -500 V to -350 V is applied to the substrate, and a current of 40 A to 50 A is passed through a tungsten filament in the reaction vessel to subject the surface of the substrate to ion bombardment of the Ar gas. After the surface of the substrate is subjected to ion bombardment, the reaction vessel is evacuated to a pressure of 1.0×10⁻² Pa or less.

When a first layer used in the present embodiment is formed, the temperature of the substrate is controlled to 400°C to 500°C, N₂ gas is introduced into the reaction vessel, and the pressure in the reaction vessel is set to 2.0 Pa to 8.0 Pa. Then, a bias voltage of -250 V to -10 V is applied to the substrate, and a metal evaporation source corresponding to the metal components of the first layer is evaporated by arc discharge at an arc current of 50 A to 200 A, thereby the first layer may be formed.

When a second layer used in the present embodiment is formed, the temperature of the substrate is controlled to 400°C to 500°C, N₂ gas is introduced into the reaction vessel, and the pressure in the reaction vessel is set to 2.0 Pa to 8.0 Pa. Then, a bias voltage of -400 V to -50 V is applied to the substrate, and a metal evaporation source corresponding to the metal components of the second layer is evaporated by arc discharge at an arc current of 50 A to 200 A, thereby the second layer may be formed.

In the present embodiment, when forming an alternately layered structure in which first and second layers are alternately formed two or more times, a lamination unit including first and second layers may be repeatedly formed in such a manner that a metal evaporation source corresponding to the metal components of the first layer and a metal evaporation source corresponding to the metal components of the second layer are evaporated by arc discharge under the conditions described above in a predetermined order. The arc discharge time of the metal evaporation source corresponding to the metal components of the first layer and the arc discharge time of the metal evaporation source corresponding to the metal components of the second layer can be each adjusted to control the thickness of each layer that constitutes the alternately layered structure.

In order to set the composition of all compounds in the first and second layers used in the present embodiment to a predetermined value, the thicknesses of the first and second layers, and the ratio of metal elements in the first and second layers may be adjusted in the process of forming the first and second layers. When forming an alternately layered structure in which first and second layers are alternately formed two or more times, the thickness of each layer in the layered structure and the ratio of metal elements in each layer may be adjusted in the process of forming the alternately layered structure.

In the first and second layers, the area proportion of crystal grains showing a GOS value of 2 degrees or more can be controlled within the above specific range by, for example, adjusting the bias voltage in the process of forming the first and second layers, adjusting the Al ratio in the compounds represented by the above formulas (1) and (2), or adjusting the average thickness of each first layer and each second layer. More specifically, if there is a large difference between the bias voltage in the process of forming the first layer and the bias voltage in the process of forming the second layer, the area proportion of crystal grains showing a GOS value of 2 degrees or more tends to increase. If a higher negative bias voltage is applied in the process of forming the first and second layers, the area proportion of crystal grains showing a GOS value of 2 degrees or more tends to increase. Furthermore, if the difference between the Al ratio y1 in the compound represented by the above formula (1) and the Al ratio y2 in the compound represented by the above formula (2) is increased, the area proportion of crystal grains showing a GOS value of 2 degrees or more tends to increase. In addition, if the average thickness of each first layer and each second layer is increased, the area proportion of crystal grains showing a GOS value of 2 degrees or more tends to increase.

The average aspect ratio of the crystal grains that constitute the first and second layers can be controlled within the above specific range by, for example, adjusting the bias voltage and arc current in the process of forming the first and second layers, or adjusting the Al ratio in the compounds represented by the above formulas (1) and (2). More specifically, if the difference between the bias voltage in the process of forming the first layer and the bias voltage in the process of forming the second layer is reduced, the average aspect ratio of the crystal grains that constitute the first and second layers tends to increase. If the arc current is reduced in the process of forming the first and second layers, the average aspect ratio of the crystal grains that constitute the first and second layers tends to increase. Furthermore, if the difference between the Al ratio y1 in the compound represented by the above formula (1) and the Al ratio y2 in the compound represented by the above formula (2) is increased, the average aspect ratio of the crystal grains that constitute the first and second layers tends to decrease. In addition, when forming an alternately layered structure in which first and second layers are alternately formed two or more times, if the number of repetitions is increased, the average aspect ratio of the crystal grains that constitute the first and second layers tends to decrease.

The average grain size of the crystal grains that constitute the first and second layers can be controlled within the above specific range by, for example, adjusting the bias voltage in the process of forming the first and second layers, adjusting the Al ratio in the average composition of all compounds represented by the above formula (3) in the first and second layers, or adjusting the average thickness of each first layer and each second layer. More specifically, if a higher negative bias voltage is applied in the process of forming the first and second layers, the average grain size of the crystal grains that constitute the first and second layers tends to decrease. If the Al ratio y in the average composition of all compounds represented by the above formula (3) in the first and second layers is reduced, the average grain size of the crystal grains that constitute the first and second layers tends to increase. Furthermore, if the average thickness of each first layer and each second layer is increased, the average grain size of the crystal grains that constitute the first and second layers tends to increase. In addition, when forming an alternately layered structure in which first and second layers are alternately formed two or more times, if the number of repetitions is increased, the average grain size of the crystal grains that constitute the first and second layers tends to decrease.

The thickness of each layer that constitutes the coating layer in the coated cutting tool of the present embodiment can be measured from the cross-sectional structure of the coated cutting tool using an optical microscope, SEM, a transmission electron microscope (hereinafter also referred to as "TEM"), or the like. The average thickness of each layer in the coated cutting tool of the present embodiment can be determined by measuring the thickness of each layer from three or more cross-sections in the vicinity of a position 50 µm from the cutting edge tip of the surface facing the metal evaporation source toward the center of the surface, and calculating the average value (arithmetic average value).

The composition of each layer that constitutes the coating layer in the coated cutting tool of the present embodiment can be measured from the cross-sectional structure of the coated cutting tool of the present embodiment using an energy dispersive X-ray analyzer (hereinafter also referred to as "EDS"), a wavelength dispersive X-ray analyzer, or the like.

At least due to its excellent wear resistance and fracture resistance, the coated cutting tool of the present embodiment is considered to have a longer tool life than conventional cutting tools, and further have excellent machined surface quality (however, the factor that can extend the tool life is not limited to the above). Specific examples of the type of the coated cutting tool of the present embodiment include indexable cutting inserts for milling or turning, drills, end mills, and the like.

### [Examples]

The present invention will be described in more detail below with reference to Examples; however, the present invention is not limited to these Examples.

### (Example 1: Invention Products 1 to 24 and Comparative Products 1 to 17)

A metal evaporation source was placed in the reaction vessel of arc ion plating equipment so that each layer had the composition of the compound shown in Tables 1 and 2. Substrates used in cutting tests 1 and 2 described later were each fixed to the fixture of a rotating table in the reaction vessel.

Thereafter, the reaction vessel was evacuated to a pressure of 5.0×10⁻³ Pa or less. After evacuation, the substrate was heated to a temperature of 450°C using a heater inside the reaction vessel. After heating, Ar gas was introduced into the reaction vessel to a pressure of 2.7 Pa.

In an Ar gas atmosphere at a pressure of 2.7 Pa, a bias voltage of -400 V was applied to the substrate, and a current of 40 A was passed through a tungsten filament in the reaction vessel to subject the surface of the substrate to ion bombardment of the Ar gas for 30 minutes. After the end of ion bombardment, the reaction vessel was evacuated to a pressure of 5.0x10⁻³ Pa or less.

For Invention Products 1 to 24 and Comparative Products 1 to 14, first and second layers were formed in order on the surface of the substrate, for Comparative Product 15, only a first layer was formed on the surface of the substrate, and for Comparative Products 16 and 17, only a second layer was formed on the surface of the substrate, as described below.

First, after evacuation, the temperature of each substrate was controlled to the temperature shown in Table 5 (temperature at the start of film formation), nitrogen gas (N₂) was introduced into the reaction vessel, and the pressure in the reaction vessel was adjusted as shown in Table 5. Then, the bias voltage shown in Table 5 was applied to the substrate, and the metal evaporation source of the composition shown in Table 1 in each layer was evaporated in the above order by the arc discharge of the arc current shown in Table 5. For Invention Products 1 to 24 and Comparative Products 1 to 14, first and second layers were formed in order on the surface of the substrate, for Comparative Product 15, only a first layer was formed on the surface of the substrate, and for Comparative Products 16 and 17, only a second layer was formed on the surface of the substrate. The number of repetitions in Invention Products 1 to 24 and Comparative Products 1 to 14 was one. For Comparative Product 15, a single first layer was formed on the surface of the substrate, and for Comparative Products 16 and 17, a single second layer was formed on the surface of the substrate. At this time, the pressure in the reaction vessel was controlled as shown in Table 5. The thicknesses of the first and second layers were controlled to the average thickness shown in Table 1 by adjusting each arc discharge time.

After the first layer and/or the second layer was formed on the surface of the substrate to the specific average thickness shown in Table 1, the power of the heater was turned off, and after the sample temperature reached 100°C or lower, the sample was taken out from the reaction vessel. Thus, coated cutting tools of Invention Products 1 to 24 and Comparative Products 1 to 17 were obtained.

### (Example 2: Invention Products 25 to 47 and Comparative Products 18 to 34)

A metal evaporation source was placed in the reaction vessel of arc ion plating equipment so that each layer had the composition of the compound shown in Tables 3 and 4. Substrates used in cutting tests 1 and 2 described later were each fixed to the fixture of a rotating table in the reaction vessel.

Thereafter, the reaction vessel was evacuated to a pressure of 5.0×10⁻³ Pa or less. After evacuation, the substrate was heated to a temperature of 450°C using a heater inside the reaction vessel. After heating, Ar gas was introduced into the reaction vessel to a pressure of 2.7 Pa.

In an Ar gas atmosphere at a pressure of 2.7 Pa, a bias voltage of -400 V was applied to the substrate, and a current of 40 A was passed through a tungsten filament in the reaction vessel to subject the surface of the substrate to ion bombardment of the Ar gas for 30 minutes. After the end of ion bombardment, the reaction vessel was evacuated to a pressure of 5.0×10⁻³ Pa or less.

For Invention Products 25 to 47 and Comparative Products 18 to 34, a lamination unit composed of first and second layers in order was formed on the surface of the substrate as described below.

First, after evacuation, the temperature of each substrate was controlled to the temperature shown in Table 6 (temperature at the start of film formation), nitrogen gas (N₂) was introduced into the reaction vessel, and the pressure in the reaction vessel was adjusted as shown in Table 6. Then, the bias voltage shown in Table 6 was applied to the substrate, and the metal evaporation source of the composition shown in Tables 3 and 4 in each layer was evaporated in the order of the lamination unit described above by the arc discharge of the arc current shown in Table 6 to form lamination units composed of each layer in the order described above on the surface of the substrate so that the number of repetitions was as shown in Table 3. At this time, the pressure in the reaction vessel was controlled as shown in Table 6. The thickness of each first layer and each second layer was controlled to the average thickness of each layer shown in Table 3 by adjusting each arc discharge time. The total average thickness of the alternately layered structure composed of the first and second layers shown in Table 3 indicates the average thickness of each first layer and each second layer, and the thickness of the alternately layered structure formed by the number of repetitions of the lamination unit composed of first and second layers.

After the alternately layered structure composed of first and second layers was formed on the surface of the substrate to the specific average thickness shown in Table 3, the power of the heater was turned off, and after the sample temperature reached 100°C or lower, the sample was taken out from the reaction vessel. Thus, coated cutting tools of Invention Products 25 to 47 and Comparative Products 18 to 34 were obtained.

### (Average Thickness of Each Layer)

The average thickness of each layer in the resulting sample was measured by using a commercially available TEM. Specifically, three cross-sections were observed with the TEM in the vicinity of a position 50 µm from the cutting edge tip of the surface of the coated cutting tool facing the metal evaporation source toward the center of the surface, the thickness of each layer was measured, and the average value (arithmetic average value) was calculated. When the sample had an alternately layered structure in which first and second layers were alternately formed two or more times, the average thickness of each first layer was calculated as a value obtained by dividing the total thickness of all first layers by the number of first layers (i.e., the number of repetitions). Similarly, the average thickness of each second layer was calculated as a value obtained by dividing the total thickness of all second layers by the number of second layers (i.e., the number of repetitions). The results are shown in Tables 1 and 3.

### (Composition of Each Compound)

The composition of each of the compounds represented by the formulas (1) and (2) in the resulting sample was measured using EDS attached to a commercially available TEM at three cross-sections in the vicinity of a position 50 µm from the cutting edge tip toward the center of the surface of the coated cutting tool facing the metal evaporation source. Specifically, the compositions of all the first and second layers included in the coating layer were analyzed. The average (arithmetic average) of the compositions of the first and second layers obtained was calculated and used as the composition of each compound. The results are shown in Tables 1 to 4. The values of x and y in the average composition (CrₓAl_{y}M_{1-x-y})N represented by the formula (3) of all compounds in the first and second layers were measured using EDS attached to the TEM. Specifically, area analysis was performed on three cross-sections in the vicinity of a position 50 µm from the cutting edge tip toward the center of the surface of the coated cutting tool facing the metal evaporation source, and the average value (arithmetic average value) was determined to be the average composition. At this time, the measurement range for the area analysis was set to include all first and second layers included in the coating layer along a direction substantially perpendicular to the substrate surface, and to span a range of 1 µm (or more) in a direction substantially parallel to the substrate surface. The results are shown in Tables 1 to 4.

### (GOS Value)

A sample of the coated cutting tool was polished in a direction substantially perpendicular to the surface of the substrate to expose cross-sections of the first and second layers. The exposed cross-sections were polished using diamond paste, and then final polishing was performed using colloidal silica to obtain a mirror-polished cross-sectional structure of the first and second layers. The sample having the cross-sectional structure of the first and second layers was set in a field emission scanning electron microscope (hereinafter referred to as "FE-SEM"), and the cross-sectional structure was irradiated with an electron beam at an angle of incidence of 70 degrees, an acceleration voltage of 15 kV, and an irradiation current of 1.0 nA. Using EBSD (manufactured by TSL Solutions K.K.), each measurement area in the cross-sections of the first and second layers was divided into pixels. For each of the divided pixels, a Kikuchi pattern was obtained from the backscattered electrons from the electron beam incident on the cross-section (mirror-polished surface) of the sample, and the pixel orientation was measured. The obtained orientation data were analyzed by using the analysis software of the EBSD, and various parameters were calculated. The measurement range was 20 µm in a direction substantially parallel to the substrate surface with a range including all first and second layers in a direction substantially perpendicular to the substrate surface, and the distance between adjacent pixels (step size) was 0.02 µm. If there was a misorientation of 5 degrees or more between adjacent pixels, the border between the pixels was defined as a grain boundary. A region surrounded by grain boundaries was defined as a single crystal grain. However, a single pixel with a misorientation of 5 degrees or more from all adjacent pixels was not considered as a crystal grain, and two or more connected pixels were treated crystal grains. Further, the intragranular misorientation between two different pixels in the same crystal grain was determined, and the average intragranular misorientation was defined as the GOS value. That is, the GOS value was calculated by the following formula (4).$GOS = \frac{{\sum }_{i , j = 1}^{n} {α}_{ij \left(i\neq j\right)}}{n \left(n-1\right)}$ (4)

In the formula (4), n represents the number of pixels in the same crystal grain, i and j represent numbers assigned to different pixels in the crystal grain (wherein 1≤i and j≤n), and αᵢⱼ (i#j) represents the misorientation resulting from the crystal orientation at pixel i and the crystal orientation at pixel j.

Measurements were carried out in any five fields of view under the above measurement conditions and within the above measurement range. Next, the total number of pixels belonging to the crystal grains that constitute the first and second layers was determined, the GOS value was divided into one-degree intervals, and the number of pixels in crystal grains whose GOS values were within the range of the value was summed up, followed by dividing by the total number of pixels, thereby creating a histogram that showed the area proportion of GOS values in the first and second layers. Based on the created histogram, the area proportion of crystal grains showing a GOS value of 2 degrees or more in the first and second layers was determined. The results are shown in Tables 2 and 4.

### (Average Grain Size and Average Aspect Ratio of Crystal Grains That Constitute First and Second Layers)

The average grain size and average aspect ratio of the crystal grains that constitute the first and second layers of the resulting sample were measured using EBSD attached to a commercially available SEM. Specifically, the resulting sample was polished in a direction substantially perpendicular to the surface of the substrate to expose cross-sections of the first and second layers. The exposed cross-sections were polished using diamond paste, and then final polishing was performed using colloidal silica to obtain a mirror-polished cross-sectional structure of the first and second layers. The sample having the cross-sectional structure of the first and second layers was set in FE-SEM, and the cross-sectional structure was irradiated with an electron beam at an angle of incidence of 70 degrees, an acceleration voltage of 15 kV, and an irradiation current of 1.0 nA. Using EBSD (manufactured by TSL Solutions K.K.), each measurement area in the cross-sections of the first and second layers was divided into pixels. For each of the divided pixels, a Kikuchi pattern was obtained from the backscattered electrons from the electron beam incident on the cross-section (mirror-polished surface) of the sample, and the pixel orientation was measured. The measurement range was 20 µm in a direction substantially parallel to the substrate surface with a range including all first and second layers in a direction substantially perpendicular to the substrate surface, and the distance between adjacent pixels (step size) was 0.02 µm. If there was a misorientation of 5 degrees or more between adjacent pixels, the border between the pixels was defined as a grain boundary. A region surrounded by grain boundaries was defined as a single crystal grain. However, a single pixel with a misorientation of 5 degrees or more from all adjacent pixels was not considered as a crystal grain, and two or more connected pixels were treated crystal grains. As for the average grain size, the circle equivalent diameter of each grain included in the analyzed field of view was determined, and the area-based average value was calculated as the average grain size. As for the average aspect ratio, a diameter A in the thickness direction of the coating layer of each grain included in the analyzed field of view, and a diameter B in the direction perpendicular to the thickness direction of the coating layer were determined, a value obtained by dividing the diameter A by the diameter B was used as the aspect ratio (diameter A/diameter B) for each grain, and the area-based average value was calculated from the obtained value to obtain the average aspect ratio. The results are shown in Tables 2 and 4.

**[Table 1]**

| Sample number | Coating layer | | | | | | | | | | | | | |
|---|---|---|---|---|---|---|---|---|---|---|---|---|---|---|
| | First and second layers | | | | | | | | | | | | | Average thickness of entire coating layer (µm) |
| | First layer: (Crₓ₁Al_{y1}M_{1-x1-y1})N | | | | | | Second layer: (Crₓ₂Al_{y2}M_{1-x2-y2})N | | | | | | Total average thickness (µm) | |
| | x1 | y1 | x1+y1 | M | | Average thickness (nm) | x2 | y2 | x2+y2 | M | | Average thickness (nm) | | |
| | | | | Element | 1-x1-y1 | | | | | Element | 1-x2-y2 | | | |
| Invention Product 1 | 0.30 | 0.70 | 1.00 | - | 0.00 | 450 | 0.60 | 0.40 | 1.00 | - | 0.00 | 450 | 0.9 | 0.9 |
| Invention Product 2 | 0.06 | 0.90 | 0.96 | Ti | 0.04 | 450 | 0.60 | 0.40 | 1.00 | - | 0.00 | 450 | 0.9 | 0.9 |
| Invention Product 3 | 0.40 | 0.60 | 1.00 | - | 0.00 | 450 | 0.60 | 0.40 | 1.00 | - | 0.00 | 450 | 0.9 | 0.9 |
| Invention Product 4 | 0.30 | 0.70 | 1.00 | - | 0.00 | 450 | 0.40 | 0.56 | 0.96 | Ti | 0.04 | 450 | 0.9 | 0.9 |
| Invention Product 5 | 0.30 | 0.70 | 1.00 | - | 0.00 | 450 | 0.80 | 0.20 | 1.00 | - | 0.00 | 450 | 0.9 | 0.9 |
| Invention Product 6 | 0.10 | 0.70 | 0.80 | Ti | 0.20 | 450 | 0.60 | 0.40 | 1.00 | - | 0.00 | 450 | 0.9 | 0.9 |
| Invention Product 7 | 0.30 | 0.64 | 0.94 | Ti | 0.06 | 450 | 0.60 | 0.40 | 1.00 | - | 0.00 | 450 | 0.9 | 0.9 |
| Invention Product 8 | 0.30 | 0.70 | 1.00 | - | 0.00 | 450 | 0.44 | 0.40 | 0.84 | Ti | 0.16 | 450 | 0.9 | 0.9 |
| Invention Product 9 | 0.30 | 0.70 | 1.00 | - | 0.00 | 450 | 0.60 | 0.24 | 0.84 | Ti | 0.16 | 450 | 0.9 | 0.9 |
| Invention Product 10 | 0.30 | 0.70 | 1.00 | - | 0.00 | 450 | 0.60 | 0.40 | 1.00 | - | 0.00 | 450 | 0.9 | 0.9 |
| Invention Product 11 | 0.30 | 0.70 | 1.00 | - | 0.00 | 450 | 0.60 | 0.40 | 1.00 | - | 0.00 | 450 | 0.9 | 0.9 |
| Invention Product 12 | 0.30 | 0.70 | 1.00 | - | 0.00 | 100 | 0.60 | 0.40 | 1.00 | - | 0.00 | 100 | 0.2 | 0.2 |
| Invention Product 13 | 0.30 | 0.70 | 1.00 | - | 0.00 | 250 | 0.60 | 0.40 | 1.00 | - | 0.00 | 250 | 0.5 | 0.5 |
| Invention Product 14 | 0.30 | 0.70 | 1.00 | - | 0.00 | 900 | 0.60 | 0.40 | 1.00 | - | 0.00 | 900 | 1.8 | 1.8 |
| Invention Product 15 | 0.30 | 0.70 | 1.00 | - | 0.00 | 1400 | 0.60 | 0.40 | 1.00 | - | 0.00 | 1400 | 2.8 | 2.8 |
| Invention Product 16 | 0.40 | 0.60 | 1.00 | - | 0.00 | 1400 | 0.70 | 0.30 | 1.00 | - | 0.00 | 1400 | 2.8 | 2.8 |
| Invention Product 17 | 0.24 | 0.66 | 0.90 | w | 0.10 | 450 | 0.60 | 0.40 | 1.00 | - | 0.00 | 450 | 0.9 | 0.9 |
| Invention Product 18 | 0.24 | 0.60 | 0.84 | Ta | 0.16 | 450 | 0.60 | 0.40 | 1.00 | - | 0.00 | 450 | 0.9 | 0.9 |
| Invention Product 19 | 0.20 | 0.70 | 0.90 | Nb | 0.10 | 450 | 0.60 | 0.40 | 1.00 | - | 0.00 | 450 | 0.9 | 0.9 |
| Invention Product 20 | 0.24 | 0.70 | 0.94 | B | 0.06 | 450 | 0.60 | 0.40 | 1.00 | - | 0.00 | 450 | 0.9 | 0.9 |
| Invention Product 21 | 0.24 | 0.70 | 0.94 | Ti | 0.06 | 450 | 0.50 | 0.40 | 0.90 | W | 0.10 | 450 | 0.9 | 0.9 |
| Invention Product 22 | 0.24 | 0.70 | 0.94 | Ti | 0.06 | 450 | 0.50 | 0.40 | 0.90 | Mo | 0.10 | 450 | 0.9 | 0.9 |
| Invention Product 23 | 0.30 | 0.70 | 1.00 | - | 0.00 | 450 | 0.50 | 0.40 | 0.90 | V | 0.10 | 450 | 0.9 | 0.9 |
| Invention Product 24 | 0.30 | 0.70 | 1.00 | - | 0.00 | 450 | 0.58 | 0.40 | 0.98 | Si | 0.02 | 450 | 0.9 | 0.9 |
| Comparative Product 1 | 0.00 | 0.90 | 0.90 | Ti | 0.10 | 450 | 0.60 | 0.40 | 1.00 | - | 0.00 | 450 | 0.9 | 0.9 |
| Comparative Product 2 | 0.00 | 0.90 | 0.90 | Ti | 0.10 | 450 | 0.60 | 0.40 | 1.00 | - | 0.00 | 450 | 0.9 | 0.9 |
| Comparative Product 3 | 0.56 | 0.44 | 1.00 | - | 0.00 | 450 | 0.60 | 0.40 | 1.00 | - | 0.00 | 450 | 0.9 | 0.9 |
| Comparative Product 4 | 0.30 | 0.70 | 1.00 | - | 0.00 | 450 | 0.30 | 0.66 | 0.96 | Ti | 0.04 | 450 | 0.9 | 0.9 |
| Comparative Product 5 | 0.30 | 0.70 | 1.00 | - | 0.00 | 450 | 0.90 | 0.10 | 1.00 | - | 0.00 | 450 | 0.9 | 0.9 |
| Comparative Product 6 | 0.00 | 0.80 | 0.80 | Ti | 0.20 | 450 | 0.60 | 0.40 | 1.00 | - | 0.00 | 450 | 0.9 | 0.9 |
| Comparative Product 7 | 0.00 | 0.70 | 0.70 | Ti | 0.30 | 450 | 0.60 | 0.40 | 1.00 | - | 0.00 | 450 | 0.9 | 0.9 |
| Comparative Product 8 | 0.30 | 0.50 | 0.80 | Ti | 0.20 | 450 | 0.60 | 0.40 | 1.00 | - | 0.00 | 450 | 0.9 | 0.9 |
| Comparative Product 9 | 0.30 | 0.70 | 1.00 | - | 0.00 | 450 | 0.30 | 0.40 | 0.70 | Ti | 0.30 | 450 | 0.9 | 0.9 |
| Comparative Product 10 | 0.30 | 0.70 | 1.00 | - | 0.00 | 450 | 0.60 | 0.00 | 0.60 | Ti | 0.40 | 450 | 0.9 | 0.9 |
| Comparative Product 11 | 0.30 | 0.70 | 1.00 | - | 0.00 | 450 | 0.60 | 0.40 | 1.00 | - | 0.00 | 450 | 0.9 | 0.9 |
| Comparative Product 12 | 0.30 | 0.70 | 1.00 | - | 0.00 | 450 | 0.60 | 0.40 | 1.00 | - | 0.00 | 450 | 0.9 | 0.9 |
| Comparative Product 13 | 0.30 | 0.70 | 1.00 | - | 0.00 | 2000 | 0.60 | 0.40 | 1.00 | - | 0.00 | 2000 | 4.0 | 4.0 |
| Comparative Product 14 | 0.30 | 0.70 | 1.00 | - | 0.00 | 2000 | 0.60 | 0.40 | 1.00 | - | 0.00 | 2000 | 4.0 | 4.0 |
| Comparative Product 15 | 0.30 | 0.70 | 1.00 | - | 0.00 | 1000 | - | - | - | - | - | - | 1.0 | 1.0 |
| Comparative Product 16 | - | - | - | - | - | - | 0.60 | 0.40 | 1.00 | - | 0.00 | 1000 | 1.0 | 1.0 |
| Comparative Product 17 | - | - | - | - | - | - | 0.60 | 0.40 | 1.00 | - | 0.00 | 1000 | 1.0 | 1.0 |

**[Table 2]**

| Sample number | Coating layer | | | | | | | |
|---|---|---|---|---|---|---|---|---|
| | First and second layers | | | | | | | |
| | Average composition: (CrₓAl_{y}M_{1-x-y})N | | | | | Area ratio of crystal grains showing a GOS value of 2 degrees or more (area%) | Average aspect ratio | Average grain size (nm) |
| | x | y | x+y | M | | | | |
| | | | | Element | 1-x-y | | | |
| Invention Product 1 | 0.45 | 0.55 | 1.00 | - | 0.00 | 20 | 5.1 | 756 |
| Invention Product 2 | 0.33 | 0.65 | 0.98 | Ti | 0.02 | 32 | 3.5 | 663 |
| Invention Product 3 | 0.50 | 0.50 | 1.00 | - | 0.00 | 14 | 6.5 | 780 |
| Invention Product 4 | 0.35 | 0.63 | 0.98 | Ti | 0.02 | 12 | 5.3 | 618 |
| Invention Product 5 | 0.55 | 0.45 | 1.00 | - | 0.00 | 33 | 3.4 | 843 |
| Invention Product 6 | 0.35 | 0.55 | 0.90 | Ti | 0.10 | 20 | 5.0 | 747 |
| Invention Product 7 | 0.45 | 0.52 | 0.97 | Ti | 0.03 | 24 | 4.6 | 672 |
| Invention Product 8 | 0.37 | 0.55 | 0.92 | Ti | 0.08 | 20 | 5.0 | 753 |
| Invention Product 9 | 0.45 | 0.47 | 0.92 | Ti | 0.08 | 22 | 5.3 | 921 |
| Invention Product 10 | 0.45 | 0.55 | 1.00 | - | 0.00 | 11 | 5.9 | 843 |
| Invention Product 11 | 0.45 | 0.55 | 1.00 | - | 0.00 | 38 | 3.8 | 522 |
| Invention Product 12 | 0.45 | 0.55 | 1.00 | - | 0.00 | 14 | 5.0 | 639 |
| Invention Product 13 | 0.45 | 0.55 | 1.00 | - | 0.00 | 17 | 5.0 | 726 |
| Invention Product 14 | 0.45 | 0.55 | 1.00 | - | 0.00 | 28 | 5.0 | 885 |
| Invention Product 15 | 0.45 | 0.55 | 1.00 | - | 0.00 | 37 | 5.0 | 986 |
| Invention Product 16 | 0.55 | 0.45 | 1.00 | - | 0.00 | 36 | 4.8 | 1186 |
| Invention Product 17 | 0.42 | 0.53 | 0.95 | W | 0.05 | 22 | 5.1 | 753 |
| Invention Product 18 | 0.42 | 0.50 | 0.92 | Ta | 0.08 | 21 | 6.8 | 744 |
| Invention Product 19 | 0.40 | 0.55 | 0.95 | Nb | 0.05 | 18 | 4.9 | 762 |
| Invention Product 20 | 0.42 | 0.55 | 0.97 | B | 0.03 | 22 | 4.5 | 708 |
| Invention Product 21 | 0.37 | 0.55 | 0.92 | Ti, W | 0.08 | 21 | 5.3 | 747 |
| Invention Product 22 | 0.37 | 0.55 | 0.92 | Ti, Mo | 0.08 | 20 | 5.3 | 753 |
| Invention Product 23 | 0.40 | 0.55 | 0.95 | V | 0.05 | 19 | 5.2 | 762 |
| Invention Product 24 | 0.44 | 0.55 | 0.99 | Si | 0.01 | 19 | 4.5 | 651 |
| Comparative Product 1 | 0.30 | 0.65 | 0.95 | Ti | 0.05 | 50 | 2.4 | 486 |
| Comparative Product 2 | 0.30 | 0.65 | 0.95 | Ti | 0.05 | 33 | 3.3 | 654 |
| Comparative Product 3 | 0.58 | 0.42 | 1.00 | - | 0.00 | 11 | 6.0 | 672 |
| Comparative Product 4 | 0.30 | 0.68 | 0.98 | Ti | 0.02 | 12 | 6.0 | 525 |
| Comparative Product 5 | 0.60 | 0.40 | 1.00 | - | 0.00 | 40 | 1.4 | 897 |
| Comparative Product 6 | 0.30 | 0.60 | 0.90 | Ti | 0.10 | 25 | 4.4 | 702 |
| Comparative Product 7 | 0.30 | 0.55 | 0.85 | Ti | 0.15 | 20 | 5.0 | 744 |
| Comparative Product 8 | 0.45 | 0.45 | 0.90 | Ti | 0.10 | 25 | 5.6 | 570 |
| Comparative Product 9 | 0.30 | 0.55 | 0.85 | Ti | 0.15 | 20 | 5.0 | 759 |
| Comparative Product 10 | 0.45 | 0.35 | 0.80 | Ti | 0.20 | 31 | 3.0 | 1251 |
| Comparative Product 11 | 0.45 | 0.55 | 1.00 | - | 0.00 | 5 | 7.4 | 966 |
| Comparative Product 12 | 0.45 | 0.55 | 1.00 | - | 0.00 | 45 | 2.5 | 444 |
| Comparative Product 13 | 0.45 | 0.55 | 1.00 | - | 0.00 | 42 | 5.0 | 1074 |
| Comparative Product 14 | 0.45 | 0.55 | 1.00 | - | 0.00 | 27 | 7.3 | 1158 |
| Comparative Product 15 | 0.30 | 0.70 | 1.00 | - | 0.00 | 4 | 9.1 | 858 |
| Comparative Product 16 | 0.60 | 0.40 | 1.00 | - | 0.00 | 7 | 14.5 | 939 |
| Comparative Product 17 | 0.60 | 0.40 | 1.00 | - | 0.00 | 6 | 9.8 | 930 |

**[Table 3]**

| Sample number | Coating layer | | | | | | | | | | | | | | |
|---|---|---|---|---|---|---|---|---|---|---|---|---|---|---|---|
| | First and second layers (alternately layered structure) | | | | | | | | | | | | | | Average thickness of entire coating layer (µm) |
| | First layer: (Crₓ₁Al_{y1}M_{1-x1-y1})N | | | | | | Second layer: (Crₓ₂Al_{y2}M_{1-x2-y2})N | | | | | | Number of repetitions (times) | Total average thickness (µm) | |
| | x1 | y1 | x1+y1 | M | | Average thickness per layer (nm) | x2 | y2 | x2+y2 | M | | Average thickness per layer (nm) | | | |
| | | | | Element | 1-x1-y1 | | | | | Element | 1-x2-y2 | | | | |
| Invention Product 25 | 0.30 | 0.70 | 1.00 | - | 0.00 | 90 | 0.60 | 0.40 | 1.00 | - | 0.00 | 90 | 5 | 0.9 | 0.9 |
| Invention Product 26 | 0.30 | 0.70 | 1.00 | - | 0.00 | 90 | 0.60 | 0.40 | 1.00 | - | 0.00 | 90 | 5 | 0.9 | 0.9 |
| Invention Product 27 | 0.30 | 0.70 | 1.00 | - | 0.00 | 150 | 0.60 | 0.40 | 1.00 | - | 0.00 | 150 | 3 | 0.9 | 0.9 |
| Invention Product 28 | 0.08 | 0.92 | 1.00 | - | 0.00 | 90 | 0.60 | 0.40 | 1.00 | - | 0.00 | 90 | 5 | 0.9 | 0.9 |
| Invention Product 29 | 0.36 | 0.64 | 1.00 | - | 0.00 | 90 | 0.60 | 0.40 | 1.00 | - | 0.00 | 90 | 5 | 0.9 | 0.9 |
| Invention Product 30 | 0.30 | 0.70 | 1.00 | - | 0.00 | 90 | 0.40 | 0.56 | 0.96 | Ti | 0.04 | 90 | 5 | 0.9 | 0.9 |
| Invention Product 31 | 0.30 | 0.70 | 1.00 | - | 0.00 | 90 | 0.80 | 0.20 | 1.00 | - | 0.00 | 90 | 5 | 0.9 | 0.9 |
| Invention Product 32 | 0.10 | 0.70 | 0.80 | Ti | 0.20 | 90 | 0.60 | 0.40 | 1.00 | - | 0.00 | 90 | 5 | 0.9 | 0.9 |
| Invention Product 33 | 0.30 | 0.66 | 0.96 | Ti | 0.04 | 90 | 0.60 | 0.40 | 1.00 | - | 0.00 | 90 | 5 | 0.9 | 0.9 |
| Invention Product 34 | 0.30 | 0.70 | 1.00 | - | 0.00 | 90 | 0.44 | 0.40 | 0.84 | Ti | 0.16 | 90 | 5 | 0.9 | 0.9 |
| Invention Product 35 | 0.30 | 0.70 | 1.00 | - | 0.00 | 90 | 0.60 | 0.24 | 0.84 | Ti | 0.16 | 90 | 5 | 0.9 | 0.9 |
| Invention Product 36 | 0.30 | 0.70 | 1.00 | - | 0.00 | 90 | 0.60 | 0.40 | 1.00 | - | 0.00 | 90 | 5 | 0.9 | 0.9 |
| Invention Product 37 | 0.30 | 0.70 | 1.00 | - | 0.00 | 90 | 0.60 | 0.40 | 1.00 | - | 0.00 | 90 | 5 | 0.9 | 0.9 |
| Invention Product 38 | 0.30 | 0.70 | 1.00 | - | 0.00 | 3 | 0.60 | 0.40 | 1.00 | - | 0.00 | 3 | 100 | 0.6 | 0.6 |
| Invention Product 39 | 0.30 | 0.70 | 1.00 | - | 0.00 | 5 | 0.60 | 0.40 | 1.00 | - | 0.00 | 5 | 60 | 0.6 | 0.6 |
| Invention Product 40 | 0.30 | 0.70 | 1.00 | - | 0.00 | 30 | 0.60 | 0.40 | 1.00 | - | 0.00 | 30 | 10 | 0.6 | 0.6 |
| Invention Product 41 | 0.30 | 0.70 | 1.00 | - | 0.00 | 150 | 0.60 | 0.40 | 1.00 | - | 0.00 | 150 | 2 | 0.6 | 0.6 |
| Invention Product 42 | 0.30 | 0.70 | 1.00 | - | 0.00 | 160 | 0.60 | 0.40 | 1.00 | - | 0.00 | 160 | 5 | 1.6 | 1.6 |
| Invention Product 43 | 0.30 | 0.70 | 1.00 | - | 0.00 | 280 | 0.60 | 0.40 | 1.00 | - | 0.00 | 280 | 5 | 2.8 | 2.8 |
| Invention Product 44 | 0.24 | 0.66 | 0.90 | W | 0.10 | 90 | 0.60 | 0.40 | 1.00 | - | 0.00 | 90 | 5 | 0.9 | 0.9 |
| Invention Product 45 | 0.24 | 0.70 | 0.94 | Ti | 0.06 | 90 | 0.50 | 0.40 | 0.90 | W | 0.10 | 90 | 5 | 0.9 | 0.9 |
| Invention Product 46 | 0.24 | 0.70 | 0.94 | Ti | 0.06 | 90 | 0.50 | 0.40 | 0.90 | Mo | 0.10 | 90 | 5 | 0.9 | 0.9 |
| Invention Product 47 | 0.20 | 0.80 | 1.00 | - | 0.00 | 90 | 0.44 | 0.56 | 1.00 | - | 0.00 | 90 | 5 | 0.9 | 0.9 |
| Comparative Product 18 | 0.00 | 0.90 | 0.90 | Ti | 0.10 | 90 | 0.60 | 0.40 | 1.00 | - | 0.00 | 90 | 5 | 0.9 | 0.9 |
| Comparative Product 19 | 0.04 | 0.96 | 1.00 | - | 0.00 | 90 | 0.60 | 0.40 | 1.00 | - | 0.00 | 90 | 5 | 0.9 | 0.9 |
| Comparative Product 20 | 0.56 | 0.44 | 1.00 | - | 0.00 | 90 | 0.80 | 0.20 | 1.00 | - | 0.00 | 90 | 5 | 0.9 | 0.9 |
| Comparative Product 21 | 0.56 | 0.44 | 1.00 | - | 0.00 | 90 | 0.60 | 0.40 | 1.00 | - | 0.00 | 90 | 5 | 0.9 | 0.9 |
| Comparative Product 22 | 0.30 | 0.70 | 1.00 | - | 0.00 | 90 | 0.30 | 0.66 | 0.96 | Ti | 0.04 | 90 | 5 | 0.9 | 0.9 |
| Comparative Product 23 | 0.30 | 0.70 | 1.00 | - | 0.00 | 90 | 0.90 | 0.10 | 1.00 | - | 0.00 | 90 | 5 | 0.9 | 0.9 |
| Comparative Product 24 | 0.00 | 0.80 | 0.80 | Ti | 0.20 | 90 | 0.60 | 0.40 | 1.00 | - | 0.00 | 90 | 5 | 0.9 | 0.9 |
| Comparative Product 25 | 0.00 | 0.70 | 0.70 | Ti | 0.30 | 90 | 0.60 | 0.40 | 1.00 | - | 0.00 | 90 | 5 | 0.9 | 0.9 |
| Comparative Product 26 | 0.30 | 0.50 | 0.80 | Ti | 0.20 | 90 | 0.60 | 0.40 | 1.00 | - | 0.00 | 90 | 5 | 0.9 | 0.9 |
| Comparative Product 27 | 0.30 | 0.70 | 1.00 | - | 0.00 | 90 | 0.30 | 0.40 | 0.70 | Ti | 0.30 | 90 | 5 | 0.9 | 0.9 |
| Comparative Product 28 | 0.30 | 0.70 | 1.00 | - | 0.00 | 90 | 0.60 | 0.00 | 0.60 | Ti | 0.40 | 90 | 5 | 0.9 | 0.9 |
| Comparative Product 29 | 0.30 | 0.70 | 1.00 | - | 0.00 | 90 | 0.60 | 0.40 | 1.00 | - | 0.00 | 90 | 5 | 0.9 | 0.9 |
| Comparative Product 30 | 0.30 | 0.70 | 1.00 | - | 0.00 | 90 | 0.60 | 0.40 | 1.00 | - | 0.00 | 90 | 5 | 0.9 | 0.9 |
| Comparative Product 31 | 0.12 | 0.88 | 1.00 | - | 0.00 | 90 | 0.42 | 0.58 | 1.00 | - | 0.00 | 90 | 5 | 0.9 | 0.9 |
| Comparative Product 32 | 0.12 | 0.88 | 1.00 | - | 0.00 | 225 | 0.42 | 0.58 | 1.00 | - | 0.00 | 225 | 2 | 0.9 | 0.9 |
| Comparative Product 33 | 0.12 | 0.88 | 1.00 | - | 0.00 | 225 | 0.42 | 0.58 | 1.00 | - | 0.00 | 225 | 2 | 0.9 | 0.9 |
| Comparative Product 34 | 0.30 | 0.70 | 1.00 | - | 0.00 | 400 | 0.60 | 0.40 | 1.00 | - | 0.00 | 400 | 5 | 4.0 | 4.0 |

**[Table 4]**

| Sample number | Coating layer | | | | | | | |
|---|---|---|---|---|---|---|---|---|
| | First and second layers (alternately layered structure) | | | | | | | |
| | Average composition: (CrₓAl_{y}M_{1-x-y})N | | | | | Area ratio of crystal grains showing a GOS value of 2 degrees or more (area%) | Average aspect ratio | Average grain size (nm) |
| | x | y | x+y | M | | | | |
| | | | | Element | 1-x-y | | | |
| Invention Product 25 | 0.45 | 0.55 | 1.00 | - | 0.00 | 15 | 4.1 | 378 |
| Invention Product 26 | 0.45 | 0.55 | 1.00 | - | 0.00 | 15 | 1.5 | 348 |
| Invention Product 27 | 0.45 | 0.55 | 1.00 | - | 0.00 | 15 | 9.5 | 422 |
| Invention Product 28 | 0.34 | 0.66 | 1.00 | - | 0.00 | 27 | 2.4 | 333 |
| Invention Product 29 | 0.48 | 0.52 | 1.00 | - | 0.00 | 12 | 5.2 | 390 |
| Invention Product 30 | 0.35 | 0.63 | 0.98 | Ti | 0.02 | 16 | 4.2 | 309 |
| Invention Product 31 | 0.55 | 0.45 | 1.00 | - | 0.00 | 28 | 2.2 | 423 |
| Invention Product 32 | 0.35 | 0.55 | 0.90 | Ti | 0.10 | 16 | 4.0 | 375 |
| Invention Product 33 | 0.45 | 0.53 | 0.98 | Ti | 0.02 | 20 | 3.5 | 336 |
| Invention Product 34 | 0.37 | 0.55 | 0.92 | Ti | 0.08 | 15 | 3.9 | 378 |
| Invention Product 35 | 0.45 | 0.47 | 0.92 | Ti | 0.08 | 17 | 4.1 | 462 |
| Invention Product 36 | 0.45 | 0.55 | 1.00 | - | 0.00 | 11 | 5.0 | 423 |
| Invention Product 37 | 0.45 | 0.55 | 1.00 | - | 0.00 | 37 | 2.9 | 261 |
| Invention Product 38 | 0.45 | 0.55 | 1.00 | - | 0.00 | 15 | 2.8 | 126 |
| Invention Product 39 | 0.45 | 0.55 | 1.00 | - | 0.00 | 12 | 3.7 | 186 |
| Invention Product 40 | 0.45 | 0.55 | 1.00 | - | 0.00 | 12 | 5.8 | 318 |
| Invention Product 41 | 0.45 | 0.55 | 1.00 | - | 0.00 | 12 | 8.2 | 402 |
| Invention Product 42 | 0.45 | 0.55 | 1.00 | - | 0.00 | 24 | 4.0 | 444 |
| Invention Product 43 | 0.45 | 0.55 | 1.00 | - | 0.00 | 34 | 4.2 | 498 |
| Invention Product 44 | 0.42 | 0.53 | 0.95 | W | 0.05 | 18 | 4.3 | 378 |
| Invention Product 45 | 0.37 | 0.55 | 0.92 | Ti, W | 0.08 | 16 | 4.2 | 372 |
| Invention Product 46 | 0.37 | 0.55 | 0.92 | Ti, Mo | 0.08 | 16 | 4.2 | 333 |
| Invention Product 47 | 0.32 | 0.68 | 1.00 | - | 0.00 | 13 | 4.1 | 318 |
| Comparative Product 18 | 0.30 | 0.65 | 0.95 | Ti | 0.05 | 44 | 1.5 | 243 |
| Comparative Product 19 | 0.32 | 0.68 | 1.00 | - | 0.00 | 28 | 1.8 | 327 |
| Comparative Product 20 | 0.68 | 0.32 | 1.00 | - | 0.00 | 10 | 2.8 | 534 |
| Comparative Product 21 | 0.58 | 0.42 | 1.00 | - | 0.00 | 12 | 3.0 | 336 |
| Comparative Product 22 | 0.30 | 0.68 | 0.98 | Ti | 0.02 | 13 | 3.1 | 264 |
| Comparative Product 23 | 0.60 | 0.40 | 1.00 | - | 0.00 | 37 | 1.1 | 450 |
| Comparative Product 24 | 0.30 | 0.60 | 0.90 | Ti | 0.10 | 21 | 3.3 | 351 |
| Comparative Product 25 | 0.30 | 0.55 | 0.85 | Ti | 0.15 | 17 | 4.0 | 372 |
| Comparative Product 26 | 0.45 | 0.45 | 0.90 | Ti | 0.10 | 21 | 4.5 | 285 |
| Comparative Product 27 | 0.30 | 0.55 | 0.85 | Ti | 0.15 | 16 | 4.0 | 381 |
| Comparative Product 28 | 0.45 | 0.35 | 0.80 | Ti | 0.20 | 26 | 2.4 | 627 |
| Comparative Product 29 | 0.45 | 0.55 | 1.00 | - | 0.00 | 4 | 5.9 | 483 |
| Comparative Product 30 | 0.45 | 0.55 | 1.00 | - | 0.00 | 43 | 1.6 | 222 |
| Comparative Product 31 | 0.27 | 0.73 | 1.00 | - | 0.00 | 43 | 1.5 | 97 |
| Comparative Product 32 | 0.27 | 0.73 | 1.00 | - | 0.00 | 48 | 2.0 | 168 |
| Comparative Product 33 | 0.27 | 0.73 | 1.00 | - | 0.00 | 48 | 1.4 | 168 |
| Comparative Product 34 | 0.45 | 0.55 | 1.00 | - | 0.00 | 22 | 6.1 | 579 |

**[Table 5]**

| Sample number | First layer | | | | Second layer | | | |
|---|---|---|---|---|---|---|---|---|
| | Temperature (°C) | Pressure (Pa) | Bias voltage (V) | Arc current (A) | Temperature (°C) | Pressure (Pa) | Bias voltage (V) | Arc current (A) |
| Invention Product 1 | 450 | 5 | -50 | 100 | 450 | 5 | -150 | 100 |
| Invention Product 2 | 450 | 5 | -50 | 100 | 450 | 5 | -150 | 100 |
| Invention Product 3 | 450 | 5 | -50 | 100 | 450 | 5 | -150 | 100 |
| Invention Product 4 | 450 | 5 | -50 | 100 | 450 | 5 | -200 | 100 |
| Invention Product 5 | 450 | 5 | -50 | 100 | 450 | 5 | -150 | 100 |
| Invention Product 6 | 450 | 5 | -50 | 100 | 450 | 5 | -150 | 100 |
| Invention Product 7 | 450 | 5 | -50 | 100 | 450 | 5 | -200 | 100 |
| Invention Product 8 | 450 | 5 | -50 | 100 | 450 | 5 | -150 | 100 |
| Invention Product 9 | 450 | 5 | -30 | 100 | 450 | 5 | -100 | 100 |
| Invention Product 10 | 450 | 5 | -30 | 100 | 450 | 5 | -100 | 100 |
| Invention Product 11 | 450 | 5 | -150 | 100 | 450 | 5 | -300 | 100 |
| Invention Product 12 | 450 | 5 | -50 | 100 | 450 | 5 | -150 | 100 |
| Invention Product 13 | 450 | 5 | -50 | 100 | 450 | 5 | -150 | 100 |
| Invention Product 14 | 450 | 5 | -50 | 100 | 450 | 5 | -150 | 100 |
| Invention Product 15 | 450 | 5 | -50 | 100 | 450 | 5 | -150 | 100 |
| Invention Product 16 | 450 | 5 | -50 | 100 | 450 | 5 | -150 | 100 |
| Invention Product 17 | 450 | 5 | -50 | 100 | 450 | 5 | -150 | 100 |
| Invention Product 18 | 450 | 5 | -50 | 100 | 450 | 5 | -150 | 100 |
| Invention Product 19 | 450 | 5 | -50 | 100 | 450 | 5 | -150 | 100 |
| Invention Product 20 | 450 | 5 | -50 | 100 | 450 | 5 | -150 | 100 |
| Invention Product 21 | 450 | 5 | -50 | 100 | 450 | 5 | -150 | 100 |
| Invention Product 22 | 450 | 5 | -50 | 100 | 450 | 5 | -150 | 100 |
| Invention Product 23 | 450 | 5 | -50 | 100 | 450 | 5 | -150 | 100 |
| Invention Product 24 | 450 | 5 | -50 | 100 | 450 | 5 | -150 | 100 |
| Comparative Product 1 | 450 | 5 | -150 | 100 | 450 | 5 | -300 | 100 |
| Comparative Product 2 | 450 | 5 | -50 | 100 | 450 | 5 | -150 | 100 |
| Comparative Product 3 | 450 | 5 | -100 | 100 | 450 | 5 | -250 | 100 |
| Comparative Product 4 | 450 | 5 | -100 | 100 | 450 | 5 | -250 | 100 |
| Comparative Product 5 | 450 | 5 | -50 | 100 | 450 | 5 | -150 | 100 |
| Comparative Product 6 | 450 | 5 | -50 | 100 | 450 | 5 | -150 | 100 |
| Comparative Product 7 | 450 | 5 | -50 | 100 | 450 | 5 | -150 | 100 |
| Comparative Product 8 | 450 | 5 | -150 | 100 | 450 | 5 | -300 | 100 |
| Comparative Product 9 | 450 | 5 | -50 | 100 | 450 | 5 | -150 | 100 |
| Comparative Product 10 | 450 | 5 | -30 | 100 | 450 | 5 | -50 | 100 |
| Comparative Product 11 | 450 | 5 | -30 | 100 | 450 | 5 | -50 | 100 |
| Comparative Product 12 | 450 | 5 | -200 | 100 | 450 | 5 | -400 | 100 |
| Comparative Product 13 | 450 | 5 | -50 | 100 | 450 | 5 | -150 | 100 |
| Comparative Product 14 | 450 | 5 | -30 | 100 | 450 | 5 | -50 | 100 |
| Comparative Product 15 | 450 | 5 | -50 | 100 | - | - | - | - |
| Comparative Product 16 | - | - | - | - | 450 | 5 | -150 | 100 |
| Comparative Product 17 | - | - | - | - | 450 | 5 | -150 | 150 |

**[Table 6]**

| Sample number | First layer | | | | Second layer | | | |
|---|---|---|---|---|---|---|---|---|
| | Temperature (°C) | Pressure (Pa) | Bias voltage (V) | Arc current (A) | Temperature (°C) | Pressure (Pa) | Bias voltage (V) | Arc current (A) |
| Invention Product 25 | 450 | 5 | -50 | 100 | 450 | 5 | -150 | 100 |
| Invention Product 26 | 450 | 5 | -50 | 180 | 450 | 5 | -150 | 180 |
| Invention Product 27 | 450 | 5 | -50 | 80 | 450 | 5 | -150 | 80 |
| Invention Product 28 | 450 | 5 | -50 | 100 | 450 | 5 | -150 | 100 |
| Invention Product 29 | 450 | 5 | -70 | 100 | 450 | 5 | -170 | 100 |
| Invention Product 30 | 450 | 5 | -100 | 100 | 450 | 5 | -250 | 100 |
| Invention Product 31 | 450 | 5 | -50 | 100 | 450 | 5 | -150 | 100 |
| Invention Product 32 | 450 | 5 | -50 | 100 | 450 | 5 | -150 | 100 |
| Invention Product 33 | 450 | 5 | -50 | 100 | 450 | 5 | -200 | 100 |
| Invention Product 34 | 450 | 5 | -50 | 100 | 450 | 5 | -150 | 100 |
| Invention Product 35 | 450 | 5 | -30 | 100 | 450 | 5 | -100 | 100 |
| Invention Product 36 | 450 | 5 | -50 | 100 | 450 | 5 | -120 | 100 |
| Invention Product 37 | 450 | 5 | -200 | 100 | 450 | 5 | -350 | 100 |
| Invention Product 38 | 450 | 5 | -80 | 90 | 450 | 5 | -180 | 90 |
| Invention Product 39 | 450 | 5 | -50 | 90 | 450 | 5 | -150 | 90 |
| Invention Product 40 | 450 | 5 | -50 | 90 | 450 | 5 | -150 | 90 |
| Invention Product 41 | 450 | 5 | -100 | 90 | 450 | 5 | -200 | 90 |
| Invention Product 42 | 450 | 5 | -50 | 100 | 450 | 5 | -150 | 100 |
| Invention Product 43 | 450 | 5 | -50 | 100 | 450 | 5 | -150 | 100 |
| Invention Product 44 | 450 | 5 | -50 | 100 | 450 | 5 | -150 | 100 |
| Invention Product 45 | 450 | 5 | -50 | 100 | 450 | 5 | -150 | 100 |
| Invention Product 46 | 450 | 5 | -50 | 100 | 450 | 5 | -150 | 100 |
| Invention Product 47 | 450 | 5 | -50 | 100 | 450 | 5 | -150 | 100 |
| Comparative Product 18 | 450 | 5 | -150 | 100 | 450 | 5 | -300 | 100 |
| Comparative Product 19 | 450 | 5 | -50 | 100 | 450 | 5 | -150 | 100 |
| Comparative Product 20 | 450 | 5 | -50 | 100 | 450 | 5 | -150 | 100 |
| Comparative Product 21 | 450 | 5 | -120 | 100 | 450 | 5 | -270 | 100 |
| Comparative Product 22 | 450 | 5 | -120 | 100 | 450 | 5 | -270 | 100 |
| Comparative Product 23 | 450 | 5 | -50 | 100 | 450 | 5 | -150 | 100 |
| Comparative Product 24 | 450 | 5 | -50 | 100 | 450 | 5 | -150 | 100 |
| Comparative Product 25 | 450 | 5 | -50 | 100 | 450 | 5 | -150 | 100 |
| Comparative Product 26 | 450 | 5 | -150 | 100 | 450 | 5 | -300 | 100 |
| Comparative Product 27 | 450 | 5 | -50 | 100 | 450 | 5 | -150 | 100 |
| Comparative Product 28 | 450 | 5 | -30 | 100 | 450 | 5 | -50 | 100 |
| Comparative Product 29 | 450 | 5 | -30 | 100 | 450 | 5 | -50 | 100 |
| Comparative Product 30 | 450 | 5 | -200 | 100 | 450 | 5 | -400 | 100 |
| Comparative Product 31 | 450 | 5 | -200 | 100 | 450 | 5 | -400 | 100 |
| Comparative Product 32 | 450 | 5 | -200 | 100 | 450 | 5 | -400 | 100 |
| Comparative Product 33 | 450 | 5 | -200 | 120 | 450 | 5 | -400 | 120 |
| Comparative Product 34 | 450 | 5 | -30 | 100 | 450 | 5 | -50 | 100 |

Using Invention Products 1 to 47 and Comparative Products 1 to 34 obtained above, cutting tests 1 and 2 were carried out under the following conditions. The results of each cutting test are shown in Tables 7 and 8.

### (Cutting Test 1)

Workpiece material: SUS304,
Workpiece material shape: a bar material with a diameter of 16 mm,
Cutting speed: 100 m/min,
Depth of cut: 0.5 mm,
Feed rate: 0.05 mm/rev,
Coolant: an oil-based coolant,
Insert: A substrate processed into an insert with ISO designation of DCGT11T302 having a composition of 89.8% WC-9.8% Co-0.4% Cr₃C₂ (all mass%) was prepared. The cutting edge line of the substrate was subjected to round honing with a SiC brush, after which the surface was cleaned. The resultant was used as the substrate.
Evaluation items: The tool life was defined as the time when the maximum wear width of the flank face of the sample reached 0.2 mm, or when the cutting edge portion was fractured, and the machining time up to the tool life was measured. Further, the damage form of the sample in which the tool flank face wear width reached 0.2 mm and the tool life was ended was defined as "normal wear," and the damage form of the sample in which the tool was fractured and the tool life was ended was defined as "fracture."

### (Cutting Test 2)

Workpiece material: SUS304,
Workpiece material shape: a bar material with a diameter of 16 mm,
Cutting speed: 80 m/min,
Depth of cut: 0.2 mm,
Feed rate: 0.02 mm/rev,
Coolant: An oil-based coolant,
Insert: A substrate processed into an insert with ISO designation of DCGT11T302 having a composition of 89.8% WC-9.8% Co-0.4% Cr₃C₂ (all mass%) was used. The cutting edge line of the substrate was not subjected to honing.
Evaluation items: The machining time was 60 minutes, and the state of welding to the cutting edge line after machining and the state of the machined surface of the workpiece material were observed and evaluated according to the following evaluation criteria. The state of welding to the cutting edge line after machining was observed by using SEM, and the state of the machined surface of the workpiece material was observed visually.

As for the state of welding to the cutting edge line, when there was no welding to the cutting edge line after machining, or when the welded area was 10% or less of the length of the cutting edge line that contributed to machining, the state of welding was rated as a "minimal amount," when the welded area was more than 10% and less than 50%, the state of welding was rated as a "small amount," and when the welded area was more than 50%, the state of welding was rated as a "large amount."

As for the state of the machined surface of the workpiece material, when the state of welding was a "minimal amount," the machined surface had no streaks or tears, and was glossy, which was rated as "very good." When the state of welding was a "small amount," the machined surface had no streaks or tears, which was rated as "good." When the state of welding was a "large amount," the machined surface had streaks or tears, which was rated as "cloudy white."

**[Table 7]**

| Sample number | Cutting Test 1 | | Cutting Test 2 | |
|---|---|---|---|---|
| | Tool life (min) | Damage form | State of welding to cutting edge line | State of machined surface of workpiece material |
| Invention Product 1 | 124 | Normal wear | Minimal amount | Very good |
| Invention Product 2 | 100 | Normal wear | Small amount | Good |
| Invention Product 3 | 116 | Normal wear | Minimal amount | Very good |
| Invention Product 4 | 106 | Normal wear | Small amount | Good |
| Invention Product 5 | 102 | Normal wear | Minimal amount | Very good |
| Invention Product 6 | 109 | Normal wear | Small amount | Good |
| Invention Product 7 | 122 | Normal wear | Small amount | Good |
| Invention Product 8 | 104 | Normal wear | Small amount | Good |
| Invention Product 9 | 94 | Normal wear | Small amount | Good |
| Invention Product 10 | 92 | Normal wear | Minimal amount | Very good |
| Invention Product 11 | 130 | Normal wear | Small amount | Good |
| Invention Product 12 | 90 | Normal wear | Minimal amount | Very good |
| Invention Product 13 | 100 | Normal wear | Minimal amount | Very good |
| Invention Product 14 | 116 | Normal wear | Small amount | Good |
| Invention Product 15 | 124 | Normal wear | Small amount | Good |
| Invention Product 16 | 106 | Normal wear | Small amount | Good |
| Invention Product 17 | 114 | Normal wear | Minimal amount | Very good |
| Invention Product 18 | 98 | Normal wear | Small amount | Good |
| Invention Product 19 | 102 | Normal wear | Small amount | Good |
| Invention Product 20 | 108 | Normal wear | Small amount | Good |
| Invention Product 21 | 100 | Normal wear | Minimal amount | Very good |
| Invention Product 22 | 96 | Normal wear | Minimal amount | Very good |
| Invention Product 23 | 102 | Normal wear | Small amount | Good |
| Invention Product 24 | 106 | Normal wear | Small amount | Good |
| Comparative Product 1 | 28 | Fracture | Large amount | Cloudy white |
| Comparative Product 2 | 40 | Fracture | Large amount | Cloudy white |
| Comparative Product 3 | 62 | Normal wear | Minimal amount | Very good |
| Comparative Product 4 | 32 | Fracture | Large amount | Cloudy white |
| Comparative Product 5 | 34 | Fracture | Large amount | Cloudy white |
| Comparative Product 6 | 54 | Fracture | Large amount | Cloudy white |
| Comparative Product 7 | 48 | Fracture | Large amount | Cloudy white |
| Comparative Product 8 | 66 | Normal wear | Small amount | Good |
| Comparative Product 9 | 40 | Fracture | Large amount | Cloudy white |
| Comparative Product 10 | 24 | Fracture | Large amount | Cloudy white |
| Comparative Product 11 | 36 | Fracture | Small amount | Good |
| Comparative Product 12 | 116 | Normal wear | Large amount | Cloudy white |
| Comparative Product 13 | 28 | Fracture | Large amount | Cloudy white |
| Comparative Product 14 | 38 | Fracture | Large amount | Cloudy white |
| Comparative Product 15 | 16 | Fracture | Large amount | Cloudy white |
| Comparative Product 16 | 20 | Fracture | Large amount | Cloudy white |
| Comparative Product 17 | 28 | Fracture | Large amount | Cloudy white |

**[Table 8]**

| Sample number | Cutting Test 1 | | Cutting Test 2 | |
|---|---|---|---|---|
| | Tool life (min) | Damage form | State of welding to cutting edge line | State of machined surface of workpiece material |
| Invention Product 25 | 146 | Normal wear | Minimal amount | Very good |
| Invention Product 26 | 126 | Normal wear | Minimal amount | Very good |
| Invention Product 27 | 154 | Normal wear | Minimal amount | Very good |
| Invention Product 28 | 116 | Normal wear | Minimal amount | Very good |
| Invention Product 29 | 134 | Normal wear | Minimal amount | Very good |
| Invention Product 30 | 124 | Normal wear | Small amount | Good |
| Invention Product 31 | 122 | Normal wear | Minimal amount | Very good |
| Invention Product 32 | 130 | Normal wear | Small amount | Good |
| Invention Product 33 | 144 | Normal wear | Small amount | Good |
| Invention Product 34 | 126 | Normal wear | Small amount | Good |
| Invention Product 35 | 106 | Normal wear | Small amount | Good |
| Invention Product 36 | 108 | Normal wear | Minimal amount | Very good |
| Invention Product 37 | 152 | Normal wear | Small amount | Good |
| Invention Product 38 | 120 | Normal wear | Small amount | Good |
| Invention Product 39 | 122 | Normal wear | Minimal amount | Very good |
| Invention Product 40 | 126 | Normal wear | Minimal amount | Very good |
| Invention Product 41 | 134 | Normal wear | Minimal amount | Very good |
| Invention Product 42 | 140 | Normal wear | Small amount | Good |
| Invention Product 43 | 150 | Normal wear | Small amount | Good |
| Invention Product 44 | 134 | Normal wear | Minimal amount | Very good |
| Invention Product 45 | 120 | Normal wear | Minimal amount | Very good |
| Invention Product 46 | 110 | Normal wear | Minimal amount | Very good |
| Invention Product 47 | 128 | Normal wear | Minimal amount | Very good |
| Comparative Product 18 | 38 | Fracture | Large amount | Cloudy white |
| Comparative Product 19 | 44 | Fracture | Large amount | Cloudy white |
| Comparative Product 20 | 70 | Normal wear | Minimal amount | Very good |
| Comparative Product 21 | 80 | Normal wear | Minimal amount | Very good |
| Comparative Product 22 | 38 | Fracture | Large amount | Cloudy white |
| Comparative Product 23 | 44 | Fracture | Large amount | Cloudy white |
| Comparative Product 24 | 62 | Fracture | Large amount | Cloudy white |
| Comparative Product 25 | 58 | Fracture | Large amount | Cloudy white |
| Comparative Product 26 | 72 | Normal wear | Small amount | Good |
| Comparative Product 27 | 50 | Fracture | Large amount | Cloudy white |
| Comparative Product 28 | 32 | Fracture | Large amount | Cloudy white |
| Comparative Product 29 | 44 | Fracture | Small amount | Good |
| Comparative Product 30 | 116 | Normal wear | Large amount | Cloudy white |
| Comparative Product 31 | 60 | Fracture | Large amount | Cloudy white |
| Comparative Product 32 | 76 | Normal wear | Large amount | Cloudy white |
| Comparative Product 33 | 72 | Normal wear | Large amount | Cloudy white |
| Comparative Product 34 | 58 | Fracture | Large amount | Cloudy white |

The results shown in Tables 7 and 8 indicate that the invention products had a tool life of 90 minutes or more in the cutting test 1, and that in the cutting test 2, the state of welding to the cutting edge line was a "minimal amount" or a "small amount," and the state of the machined surface of the workpiece material was "very good" or "good." On the other hand, the comparative products had a tool life of less than 90 minutes in the cutting test 1, or in the cutting test 2, the state of welding to the cutting edge line was a "large amount," and the state of the machined surface of the workpiece material was "cloudy white," or both of them. Therefore, it is found that the wear resistance and fracture resistance of the invention products are generally superior to those of the comparative products. It is also found that the invention products are excellent in the machined surface quality of the workpiece materials because welding of the workpiece materials after machining can be prevented.

The above results revealed that the invention products have excellent fracture resistance and wear resistance, a long tool life, and excellent machined surface quality.

### [Industrial Applicability]

The coated cutting tool of the present invention has excellent fracture resistance and wear resistance, and thus has a longer tool life than conventional cutting tools and excellent machined surface quality. From such a point of view, the coated cutting tool of the present invention is industrially applicable.

### [Reference Signs List]

1: substrate, 2: first layer, 3: second layer, 4: alternately layered structure, 5: coating layer, 6: coated cutting tool.

## Claims

1. A coated cutting tool comprising a substrate and a coating layer formed on the substrate,
the coating layer having a first layer containing a compound having a composition represented by the following formula (1), and
a second layer being in contact with the first layer and containing a compound having a composition represented by the following formula (2):
(Crₓ₁Al_{y1}M_{1-x1-y1})N (1)
(Crₓ₂Al_{y2}M_{1-x2-y2})N (2)
(in the formula (1), M represents at least one element selected from the group consisting of Mo, W, V, Nb, Ta, Ti, Zr, Hf, Si, and B,
x1 is the atomic ratio of Cr to the sum of elements represented by Cr, Al, and M, and satisfies 0.05≤x1≤0.40, and
y1 is the atomic ratio of Al to the sum of elements represented by Cr, Al, and M, and satisfies 0.60≤y1≤0.95, and
in the formula (2), M represents at least one element selected from the group consisting of Mo, W, V, Nb, Ta, Ti, Zr, Hf, Si, and B,
x2 is the atomic ratio of Cr to the sum of elements represented by Cr, Al, and M, and satisfies 0.40≤x2≤0.80, and y2 is the atomic ratio of Al to the sum of elements represented by Cr, Al, and M, and satisfies 0.20≤y2<0.60),
the first and second layers having an area proportion of crystal grains showing a GOS value of 2 degrees or more of 10 area% or more and less than 40 area%, and
the first and second layers having a total average thickness of 0.1 µm or more and 3.0 µm or less.

2. The coated cutting tool according to claim 1, wherein the first layer has an average thickness of 2 nm or more and 1500 nm or less, and
the second layer has an average thickness of 2 nm or more and 1500 nm or less.

3. The coated cutting tool according to claim 1 or 2, wherein crystal grains that constitute the first and second layers have an average aspect ratio of 1.5 or more and 10.0 or less.

4. The coated cutting tool according to any one of claims 1 to 3, wherein crystal grains that constitute the first and second layers have an average grain size of 100 nm or more and 1000 nm or less.

5. The coated cutting tool according to any one of claims 1 to 4, wherein all compounds in the first and second layers have an average composition represented by the following formula (3):
(CrₓAl_{y}M_{1-x-y})N (3)
(in the formula (3), M represents at least one element selected from the group consisting of Mo, W, V, Nb, Ta, Ti, Zr, Hf, Si, and B,
x is the atomic ratio of Cr to the sum of elements represented by Cr, Al, and M, and satisfies 0.30≤x≤0.60, and
y is the atomic ratio of Al to the sum of elements represented by Cr, Al, and M, and satisfies 0.40≤y≤0.70.).

6. The coated cutting tool according to any one of claims 1 to 5, wherein the coating layer has an alternately layered structure in which the first layer and the second layer are alternately formed two or more times.

7. The coated cutting tool according to any one of claims 1 to 6, wherein the entire coating layer has an average thickness of 0.1 µm or more and 3.0 µm or less.

8. The coated cutting tool according to any one of claims 1 to 7, wherein the substrate is cemented carbide, cermet, ceramics, or a cubic boron nitride sintered body.
